# EUROPEAN PATENT SPECIFICATION

(11) **EP 4 431 447 B1**
(45) Date of publication and mention of the grant of the patent: **18.03.2026**
(21) Application number: 23189874.3
(22) Date of filing: 04.08.2023
(51) Int. Cl.: G01P 15/125

(54) **SENSOR AND ELECTRONIC DEVICE**
SENSOR UND ELEKTRONISCHE VORRICHTUNG
CAPTEUR ET DISPOSITIF ÉLECTRONIQUE

(30) Priority: 13.03.2023 JP 2023038514
(43) Date of publication of application: 18.09.2024
(73) Proprietor: Kabushiki Kaisha Toshiba, Minato-ku Tokyo (JP)
(72) Inventor: MASUNISHI, Kei, Tokyo (JP); OGAWA, Etsuji, Tokyo (JP); TOMIZAWA, Yasushi, Tokyo (JP)
(74) Representative: Marks & Clerk LLP

(56) References cited:
- US-A1- 2020 025 790
- US-A1- 2023 062 441

## Description

### FIELD

Embodiments described herein relate generally to a sensor and an electronic device.

### BACKGROUND

For example, there is a sensor using a MEMS structure. It is desired to improve the characteristics of the sensor.

US2023/062441A1 discloses a sensor. The sensor includes a base, a first support portion fixed to the base, and a first movable portion supported by the first support portion. The first movable portion includes first and second movable base portions, a connecting base portion, first and second movable beams, and first and second movable conductive portions. The first movable beam includes a first beam end portion, a first beam other end portion, and a first beam intermediate portion. The second movable beam includes a second beam end portion, a second beam other end portion, and a second beam intermediate portion. The first movable conductive portion includes a first crossing conductive portion, a first extending conductive portion, and a first other extending conductive portion. The second movable conductive portion includes a second crossing conductive portion, a second extending conductive portion, and a second other extending conductive portion.

US2020/025790A1 discloses a vibrating beam accelerometer (VBA) with an in-plane translational proof mass that may include at least two or more resonators and be built with planar geometry, discrete lever arms, four-fold symmetry and a single primary mechanical anchor between the support base and the VBA.

### SUMMARY

The invention provides a sensor according to claim 1 and an electronic device according to claim 12.

### BRIEF DESCRIPTION OF THE DRAWINGS

FIG. 1 is a schematic plan view illustrating a sensor according to a first embodiment;
FIGS. 2A to 2C are schematic cross-sectional views illustrating the sensor according to the first embodiment;
FIGS. 3A to 3D are schematic cross-sectional views illustrating the sensor according to the first embodiment;
FIG. 4 is a schematic plan view illustrating the sensor according to the first embodiment;
FIGS. 5A to 5D are schematic cross-sectional views illustrating a sensor according to the first embodiment;
FIGS. 6A to 6D are schematic cross-sectional views illustrating a sensor according to the first embodiment;
FIGS. 7A to 7D are schematic cross-sectional views illustrating a sensor according to the first embodiment;
FIGS. 8A to 8D are schematic cross-sectional views illustrating a sensor according to the first embodiment;
FIGS. 9A to 9D are schematic cross-sectional views illustrating a sensor according to the first embodiment;
FIGS. 10A to 10D are schematic cross-sectional views illustrating the sensor according to the first embodiment;
FIGS. 11A and 11B are schematic plan views illustrating a part of a sensor according to the first embodiment;
FIG. 12 is a schematic plan view illustrating a sensor according to the first embodiment;
FIGS. 13A and 13B are schematic plan views illustrating the sensor according to the first embodiment;
FIG. 14 is a schematic plan view illustrating a sensor according to the first embodiment;
FIG. 15 is a schematic plan view illustrating a sensor according to the first embodiment;
FIG. 16 is a schematic plan view illustrating the sensor according to the first embodiment;
FIG. 17 is a schematic plan view illustrating a sensor according to the first embodiment;
FIG. 18 is a schematic plan view illustrating a sensor according to the first embodiment;
FIG. 19 is a schematic plan view illustrating a sensor according to the first embodiment;
FIG. 20 is a schematic plan view illustrating a sensor according to the first embodiment;
FIG. 21 is a schematic plan view illustrating a sensor according to the first embodiment;
FIG. 22 is a schematic plan view illustrating a sensor according to the first embodiment;
FIG. 23 is a schematic plan view illustrating a sensor according to the first embodiment;
FIG. 24 is a schematic plan view illustrating a sensor according to the first embodiment;
FIG. 25 is a schematic plan view illustrating a sensor according to the first embodiment;
FIG. 26 is a schematic plan view illustrating a sensor according to the first embodiment;
FIG. 27 is a schematic plan view illustrating a sensor according to the first embodiment;
FIG. 28 is a schematic diagram illustrating an electronic device according to a second embodiment;
FIGS. 29A to 29H are schematic diagrams illustrating applications of the electronic device according to the embodiment; and
FIGS. 30A and 30B are schematic diagrams illustrating applications of the sensor according to the embodiment.

### DETAILED DESCRIPTION

According to one embodiment, a sensor includes an element section. The element section includes a first beam, a first beam electrode, a second beam, and a second beam electrode. The first beam includes a first portion, a first other portion, and a first intermediate portion between the first portion and the first other portion. A direction from the first portion to the first other portion is along a first direction. The first beam electrode is connected to the first intermediate portion. The second beam includes a second portion, a second other portion, and a second intermediate portion between the second portion and the second other portion. A direction from the second portion to the second other portion is along the first direction. The second beam electrode is connected to the second intermediate portion. A second direction from the first intermediate portion to the first beam electrode crosses the first direction. A direction from the second intermediate portion to the second beam electrode is along the second direction. The first beam electrode and the second beam electrode satisfy at least one of a first condition, a second condition, a third condition, a fourth condition, a fifth condition, a sixth condition, a seventh condition or an eighth condition. In the first condition, a second mass of the second beam electrode is different from a first mass of the first beam electrode. In the second condition, at least a part of a second material included in the second beam electrode is different from at least a part of a first material included in the first beam electrode. In the third condition, a second thickness of the second beam electrode along a third direction is different from a first thickness of the first beam electrode along the third direction. The third direction crosses a plane including the first direction and the second direction. In the fourth condition, a second size of a second hole included in the second beam electrode is different from a first size of a first hole included in the first beam electrode. In the fifth condition, a second density of the second holes is different from the first density of the first holes. In the sixth condition, a second number of the second holes is different from a first number of the first holes. Or the second beam electrode includes the second holes and the first beam electrode does not include the first hole. In the seventh condition, a second layer structure of the second beam electrode is different from a first layer structure of the first beam electrode. In the eighth condition, a second shape of the second beam electrode is different from a first shape of the first beam electrode.

Various embodiments are described below with reference to the accompanying drawings.

The drawings are schematic and conceptual; and the relationships between the thickness and width of portions, the proportions of sizes among portions, etc., are not necessarily the same as the actual values. The dimensions and proportions may be illustrated differently among drawings, even for identical portions.

In the specification and drawings, components similar to those described previously or illustrated in an antecedent drawing are marked with like reference numerals, and a detailed description is omitted as appropriate.

### First Embodiment

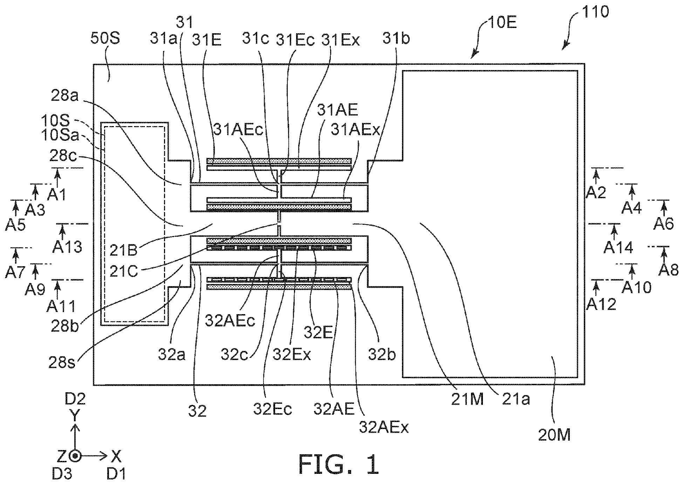

FIG. 1 is a schematic plan view illustrating a sensor according to the first embodiment.

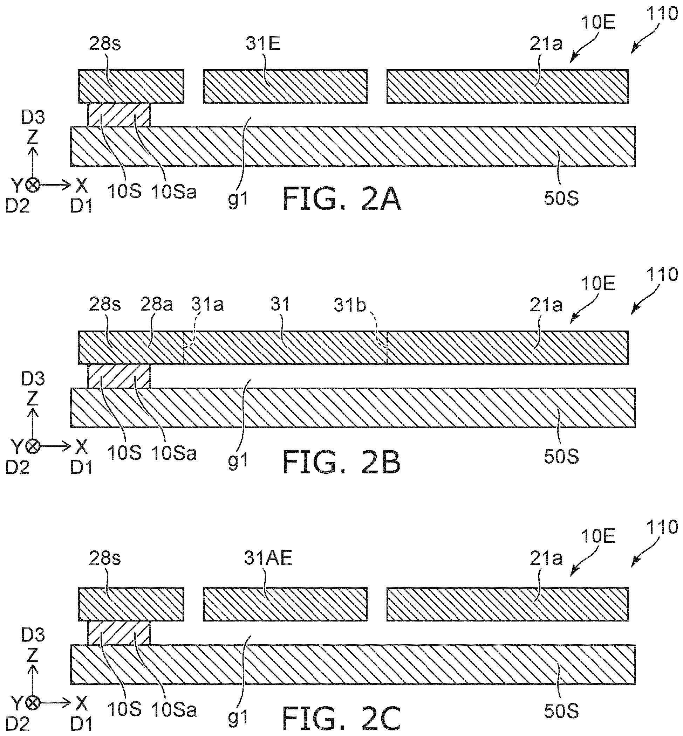

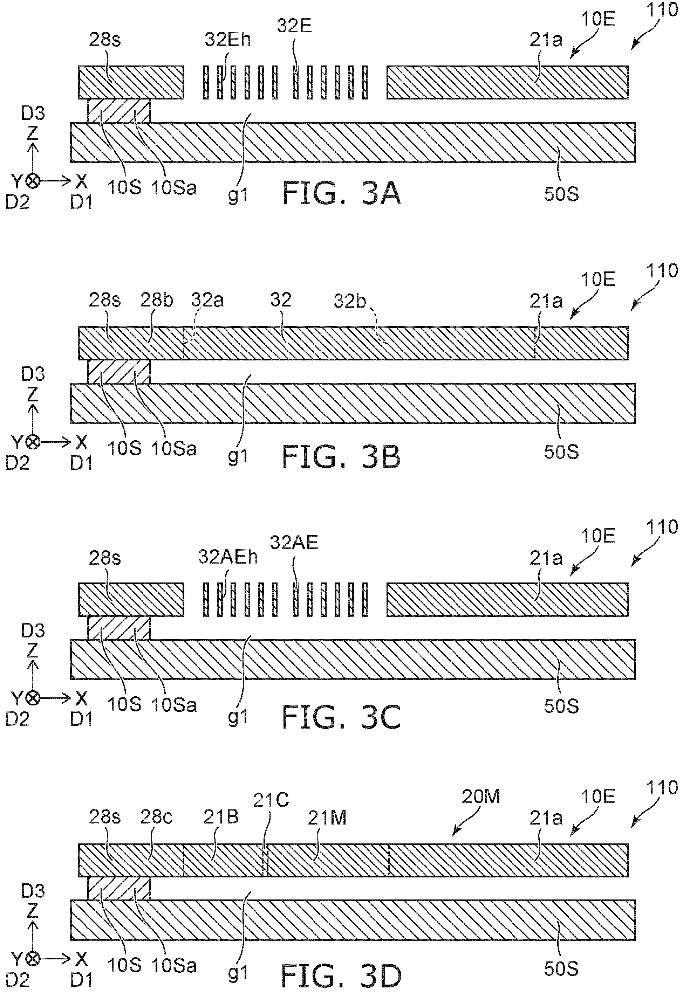

FIGS. 2A to 2C and 3A to 3D are schematic cross-sectional views illustrating the sensor according to the first embodiment.

FIGS. 2A to 2C and 3A to 3D are cross-sectional views along the line A1-A2, the line A3-A4, the line A5-A6, the line A7-A8, the line A9-A10, the line A11-A12, and the line A13-A14.

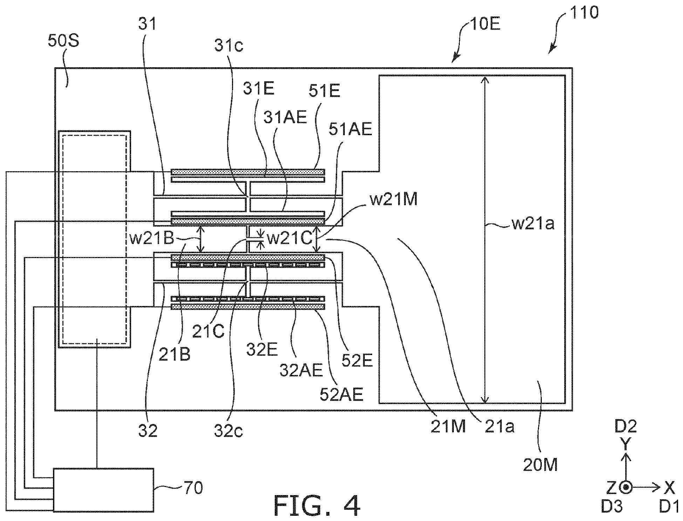

FIG. 4 is a schematic plan view illustrating the sensor according to the first embodiment.

As shown in FIG. 1, a sensor 110 according to the embodiment includes an element section 10E.

The element section 10E includes a first beam 31, a second beam 32, a first beam electrode 31E and a second beam electrode 32E.

The first beam 31 includes a first portion 31a, a first other portion 31b, and a first intermediate portion 31c. The first intermediate portion 31c is provided between the first portion 31a and the first other portion 31b. A direction from the first portion 31a to the first other portion 31b is along the first direction D1.

The first direction D1 is defined as an X-axis direction. One direction perpendicular to the X-axis direction is defined as a Y-axis direction. A direction perpendicular to the X-axis direction and the Y-axis direction is defined as a Z-axis direction.

The first beam electrode 31E is connected to the first intermediate portion 31c. A second direction D2 from the first intermediate portion 31c to the first beam electrode 31E crosses the first direction D1. The second direction D2 is, for example, the Y-axis direction.

The second beam 32 includes a second portion 32a, a second other portion 32b, and a second intermediate portion 32c. The second intermediate portion 32c is provided between the second portion 32a and the second other portion 32b. A direction from the second portion 32a to the second other portion 32b is along the first direction D1.

The second beam electrode 32E is connected to the second intermediate portion 32c. A direction from the second intermediate portion 32c to the second beam electrode 32E is along the second direction D2. In this example, a direction from the second beam 32 to the first beam 31 is along the second direction D2.

As shown in FIG. 1, in this example, the first beam electrode 31E includes a first extending portion 31Ex and a first extending connecting portion 31Ec. The first extending portion 31Ex extends along the first direction D1. The first extending connecting portion 31Ec connects the first extending portion 31Ex to the first intermediate portion 31c. The first extending connecting portion 31Ec extends, for example, along the second direction D2.

In this example, the second beam electrode 32E includes a second extending portion 32Ex and a second extending connecting portion 32Ec. The second extending portion 32Ex extends along the first direction D1. The second extending connecting portion 32Ec connects the second extending portion 32Ex to the second intermediate portion 32c. The second extending connecting portion 32Ec extends, for example, along the second direction D2.

As shown in FIGS. 2A to 2C and FIGS. 3A to 3D, the sensor 110 further includes a base 50S and a first fixed portion 10S. The first fixed portion 10S is fixed to the base 50S. A direction from the base 50S to the first fixed portion 10S is along a third direction D3. The third direction D3 crosses a plane including the first direction D1 and the second direction D2. The third direction D3 is, for example, the Z-axis direction.

The element section 10E further includes a first support portion 28s supported by the first fixed portion 10S. In this example, the first fixed portion 10S includes a first fixed region 10Sa. The first support portion 28s includes a first support region 28a and a second support region 28b. These support regions are supported on the first fixed region 10Sa.

The first portion 31a and the second portion 32a are connected to the first support portion 28s. In this example, the first portion 31a is supported by the first support region 28a. The second portion 32a is connected to the second support region 28b. A first gap g1 is provided between the base 50S and the element section 10E.

As shown in FIG. 3A, in this example, the second beam electrode 32E includes a second hole 32Eh. On the other hand, as shown in FIG. 2A, the first beam electrodes 31E are not provided with holes. In the embodiment, the configuration of the second beam electrodes 32E is different from the configuration of the first beam electrodes 31E. Thereby, the resonance characteristic of the second beam 32 differs from the resonance characteristic of the first beam 31. The resonance frequency of the second beam 32 is different from the resonance frequency of the first beam 31.

In the embodiment, the force (e.g., acceleration) applied to the element section 10E can be detected by detecting change in the resonance characteristics (e.g., resonance frequency) of the beam. In the embodiment, multiple beams with different resonance characteristics (resonance frequencies) are provided. Thereby, for example, a wide dynamic range can be provided. For example, it is possible to detect a wide dynamic range with high accuracy. According to the embodiment, it is possible to provide a sensor whose characteristics can be improved.

As shown in FIG. 4, the sensor 110 may further include a first fixed electrode 51E and a second fixed electrode 52E. The first fixed electrode 51E and the second fixed electrode 52E are fixed to the base 50S. The first fixed electrode 51E faces the first beam electrode 31E. The second fixed electrode 52E faces the second beam electrode 32E. For example, a direction from the first beam electrode 31E to the first fixed electrode 51E is along the second direction D2. For example, a direction from the second beam electrode 32E to the second fixed electrode 52E is along the second direction D2. At least a part of the first fixed electrode 51E and at least a part of the second fixed electrode 52E extend along the first direction D1.

As shown in FIG. 4, a controller 70 may be provided. The controller 70 may be included in the sensor 110. The controller 70 may be provided separately from the sensor 110. In one example, the controller 70 is configured to apply a first AC signal between the first fixed electrode 51E and the first beam electrode 31E. The controller 70 is configured to, for example, apply the first AC signal between the second fixed electrode 52E and the second beam electrode 32E. A first AC signal causes these beams to vibrate. By detecting the vibration characteristics, the received force (acceleration) can be detected.

The detecting the vibration characteristics may be performed optically. When vibrational properties are detected optically, these beams are illuminated with light and properties of the reflected light are detected. The detection of the vibration characteristics may be performed electrically, for example. If the detection of the vibration characterization is performed electrically, for example, changes in capacitance with the vibration of the beam are detected.

As shown in FIG. 4, for example, the element section 10E further includes a first opposing beam electrode 31AE and a second opposing beam electrode 32AE. The first opposing beam electrode 31AE is connected to the first intermediate portion 31c. The second opposing beam electrode 32AE is connected to the second intermediate portion 32c. The first beam 31 is provided between the first opposing beam electrode 31AE and the first beam electrode 31E in the second direction D2. The second beam 32 is provided between the second opposing beam electrode 32AE and the second beam electrode 32E in the second direction D2.

As shown in FIG. 4, for example, the sensor 110 may further include a first opposing fixed electrode 51AE and a second opposing fixed electrode 52AE fixed to the base 50S. The controller 70 is configured to detect a first signal generated between the first opposing fixed electrode 51AE and the first opposing beam electrode 31AE. The controller 70 is configured to detect a second signal generated between the second opposing fixed electrode 52AE and the second opposing beam electrode 32AE. A capacitance (first signal) between the first opposing fixed electrode 51AE and the first opposing beam electrode 31AE changes according to the vibration of the first beam 31. A change in the resonance frequency of the first beam 31 can be detected by detecting the first signal. A capacitance (second signal) between the second opposing fixed electrode 52AE and the second opposing beam electrode 32AE changes according to the vibration of the second beam 32. A change in the resonance frequency of the second beam 32 can be detected by detecting the second signal.

The controller 70 may output a signal corresponding to the difference between the first signal and the second signal. By differential processing, more accurate detection can be performed. For example, high detection results with suppressed temperature dependence can be obtained.

As shown in FIG. 1, the element section 10E may include a movable member 20M. As shown in FIG. 3D, the movable member 20M is supported by the first fixed portion 10S. In this example, the first support portion 28s includes a third support region 28c. In this example, the movable member 20M is supported by the third support region 28c.

The movable member 20M includes a first movable portion 21a. The first other portion 31b and the second other portion 32b are connected to the first movable portion 21a.

As shown in FIG. 4, the movable member 20M includes a first movable base portion 21B, a first movable intermediate portion 21M, and a first movable connecting portion 21C. The first movable base portion 21B is supported by the first fixed portion 10S. The first movable base portion 21B is supported by, for example, the third support region 28c.

The first movable intermediate portion 21M is provided between the first movable base portion 21B and the first movable portion 21a. The first movable connecting portion 21C is provided between the first movable base portion 21B and the first movable intermediate portion 21M. The first movable connecting portion 21C connects the first movable intermediate portion 21M with the first movable base portion 21B.

As shown in FIG. 4, a first movable connecting portion width w21C of the first movable connecting portion 21C in the second direction D2 is narrower than a first movable base portion width w21B of the first movable base portion 21B in the second direction D2. The first movable connecting portion width w21C is narrower than a first movable intermediate portion width w21M of the first movable intermediate portion 21M in the second direction D2. The first movable connecting portion 21C function as a pivot portion, for example. The first movable intermediate portion 21M and the first movable portion 21a are easy to move. A force is amplified. Amplified stress is applied to the first beam 31 and the second beam 32. A large change occurs in the resonance frequency of the first beam 31 and the resonance frequency of the second beam 32.

As shown in FIG. 4, a first movable portion width w21a of the first movable portion 21a in the second direction D2 is wider than the first movable connecting portion width w21C. The first movable portion 21a functions as a weight portion.

As shown in FIG. 1, in this example, the first opposing beam electrode 31AE includes a first opposing extending portion 31AEx and a first opposing extending connecting portion 31AEc. The first opposing extending portion 31AEx extends along the first direction D1. The first opposing extending connecting portion 31AEc connects the first opposing extending portion 31AEx to the first intermediate portion 31c. The first opposing extending connecting portion 31AEc extends, for example, along the second direction D2.

In this example, the second opposing beam electrode 32AE includes a second opposing extending portion 32AEx and a second opposing extending connecting portion 32AEc. The second opposing extending portion 32AEx extends along the first direction D1. The second opposing extending connecting portion 32AEc connects the second opposing extending portion 32AEx to the second intermediate portion 32c. The second opposing extending connecting portion 32AEc extends, for example, along the second direction D2.

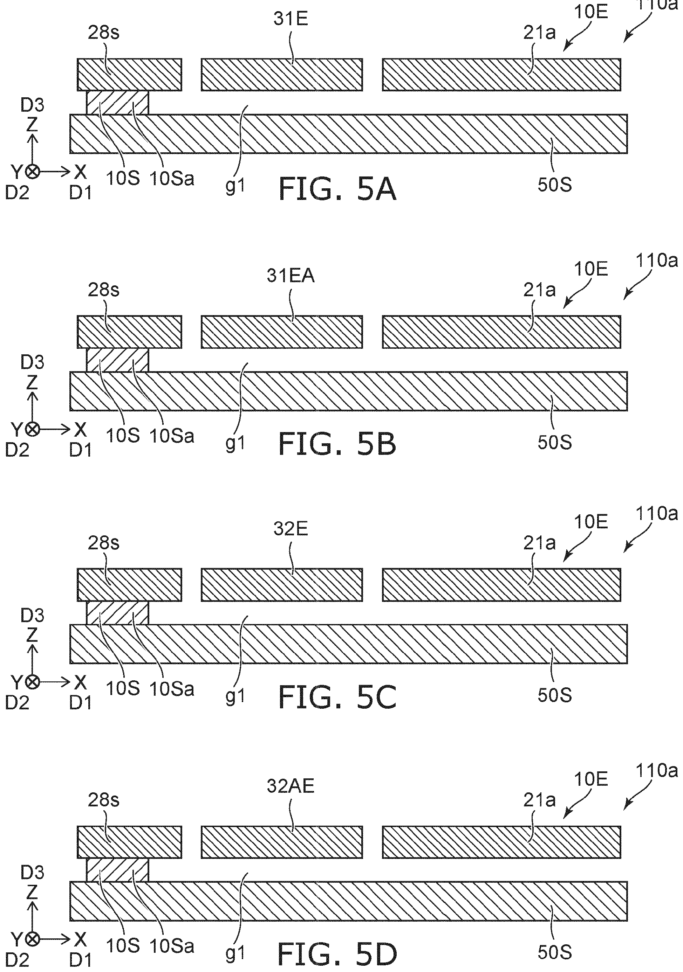

FIGS. 5A to 5D are schematic cross-sectional views illustrating a sensor according to the first embodiment.

FIGS. 5A to 5D are cross-sectional views corresponding to the lines A1-A2, A5-A6, A7-A8, and A11-A12 in FIG. 1.

In a sensor 110a according to the embodiment, a mass of the second beam electrode 32E is different from a mass of the first beam electrode 31E. In the sensor 110a, a mass of the second opposing beam electrode 32AE differs from a mass of the first opposing beam electrode 31AE. In the sensor 110a, the two beams have different resonance characteristics (resonance frequencies).

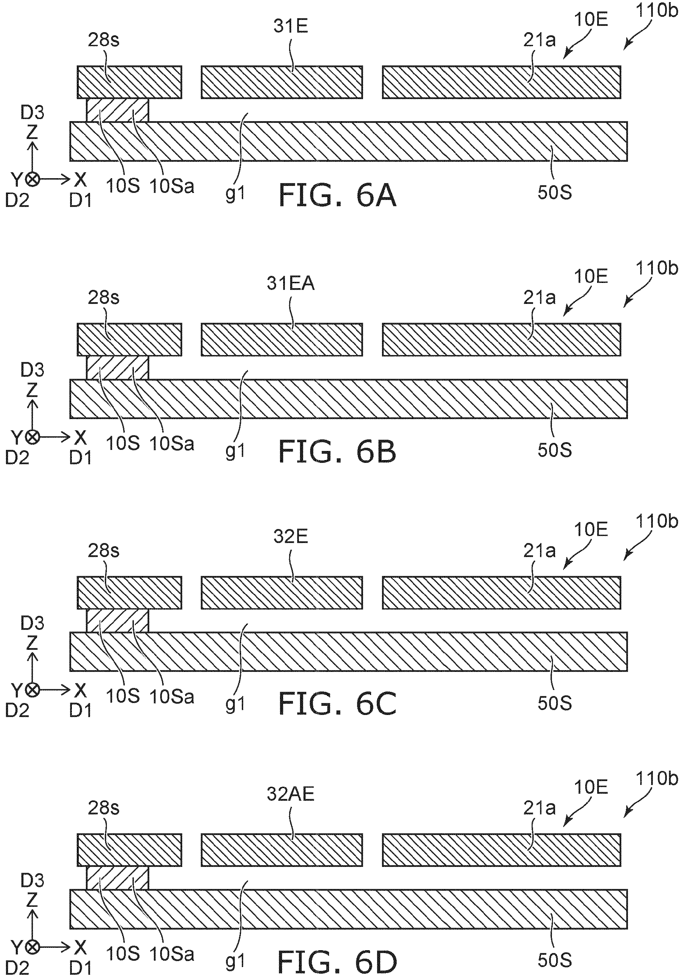

FIGS. 6A to 6D are schematic cross-sectional views illustrating a sensor according to the first embodiment.

FIGS. 6A to 6D are cross-sectional views corresponding to the lines A1-A2, A5-A6, A7-A8, and A11-A12 in FIG. 1.

In a sensor 110b according to the embodiment, at least a part of a material of the second beam electrode 32E is different from at least a part of a material of the first beam electrode 31E. In the sensor 110b, at least a part of a material of the second opposing beam electrode 32AE is different from at least a part of a material of the first opposing beam electrode 31AE. In the sensor 110b, the two beams have different resonance characteristics (resonance frequencies).

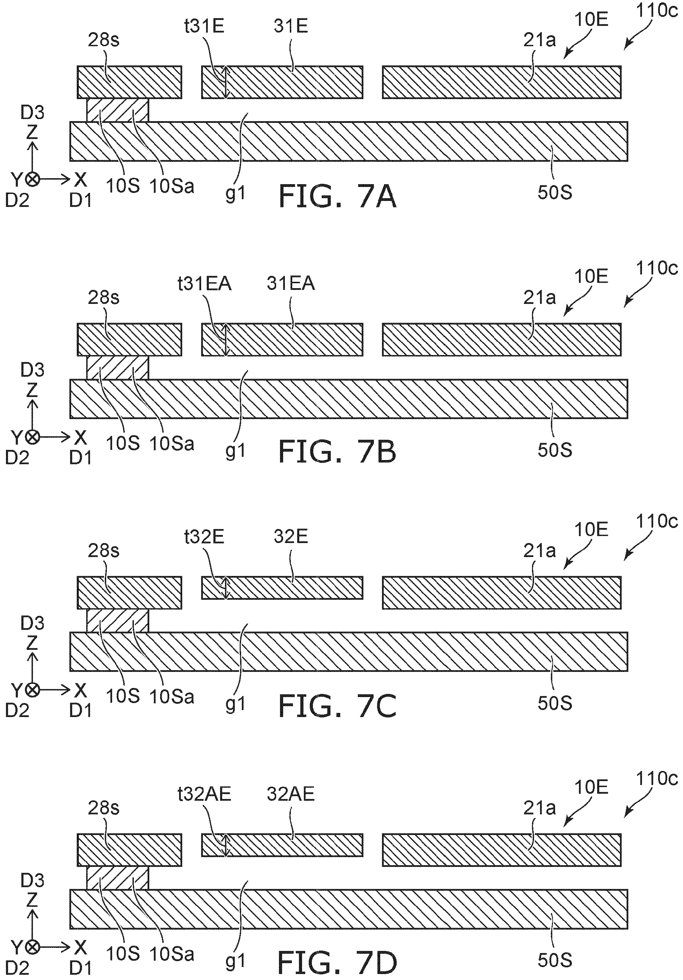

FIGS. 7A to 7D are schematic cross-sectional views illustrating a sensor according to the first embodiment.

FIGS. 7A to 7D are cross-sectional views corresponding to the lines A1-A2, A5-A6, A7-A8, and A11-A12 in FIG. 1.

In a sensor 110c according to the embodiment, a thickness along the third direction D3 of the second beam electrode 32E (second thickness t32E) is different from a thickness along the third direction D3 of the first beam electrode 31E (first thickness t31E). In the sensor 110c, a thickness along the third direction D3 of the second opposing beam electrode 32AE (second opposing thickness t32AE) is different from a thickness along the third direction D3 of the first beam electrode 31E (first thickness t31E). The two beams have different resonance characteristics (resonance frequency).

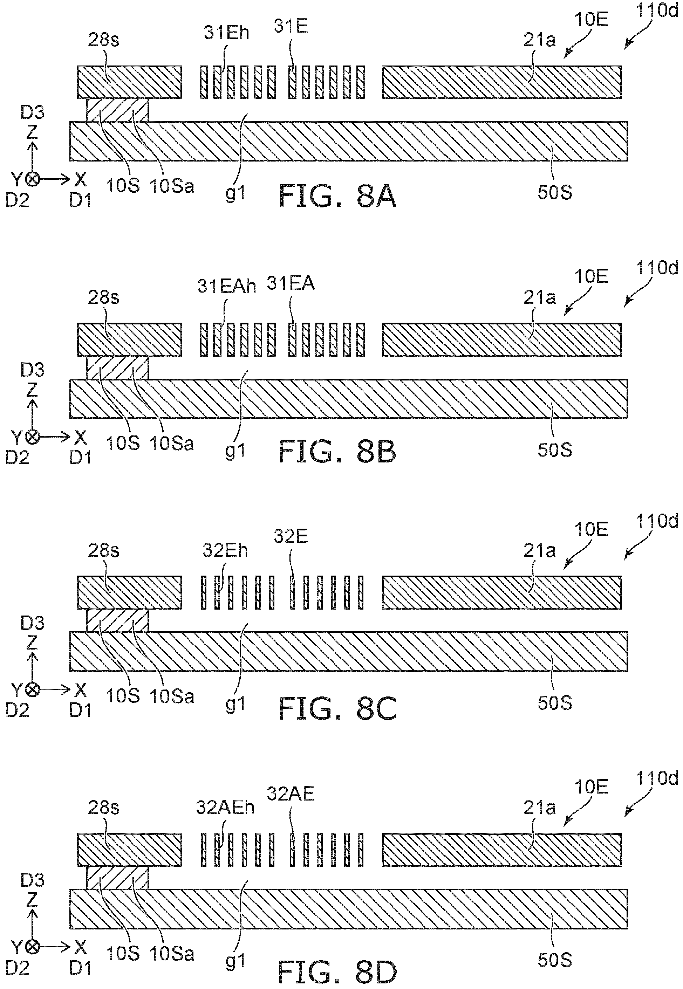

FIGS. 8A to 8D are schematic cross-sectional views illustrating a sensor according to the first embodiment.

FIGS. 8A to 8D are cross-sectional views corresponding to the lines A1-A2, A5-A6, A7-A8, and A11-A12 in FIG. 1.

In a sensor 110d according to the embodiment, a second size of the second hole 32Eh included in the second beam electrode 32E is different from a first size of the first hole 31Eh included in the first beam electrode 31E. In the sensor 110d, a second opposing size of a second opposing hole 32AEh included in the second opposing beam electrode 32AE is different from a first opposing size of a first opposing hole 31AEh included in the first opposing beam electrode 31AE. The two beams have different resonance characteristics (resonance frequencies).

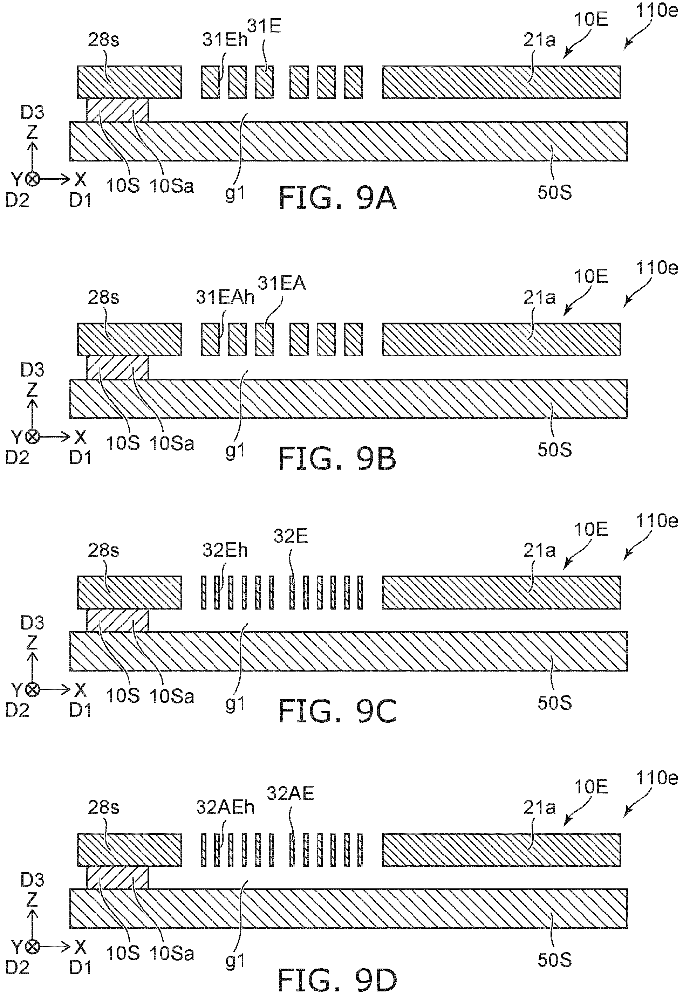

FIGS. 9A to 9D are schematic cross-sectional views illustrating a sensor according to the first embodiment.

FIGS. 9A to 9D are cross-sectional views corresponding to the lines A1-A2, A5-A6, A7-A8, and A11-A12 in FIG. 1.

In a sensor 110e according to the embodiment, a second density of the second holes 32Eh is different from a first density of the first holes 31Eh. In the sensor 110e, a second opposing density of the second opposing holes 32AEh is different from a first opposing density of the first opposing holes 31AEh. The two beams have different resonance characteristics (resonance frequencies).

In the sensor 110e, a second number of second holes 32Eh is different from a first number of first holes 31Eh. Alternatively, the second beam electrode 32E includes the second hole 32Eh and the first beam electrode 31E does not include the first hole 31Eh. In the sensor 110e, a second opposing number of the second opposing holes 32AEh is different from a first opposing number of the first opposing holes 31AEh. Alternatively, the second opposing beam electrode 32AE includes the second opposing hole 32AEh, and the first opposing beam electrode 31AE does not include the first opposing hole 31AEh. The two beams have different resonance characteristics (resonance frequencies).

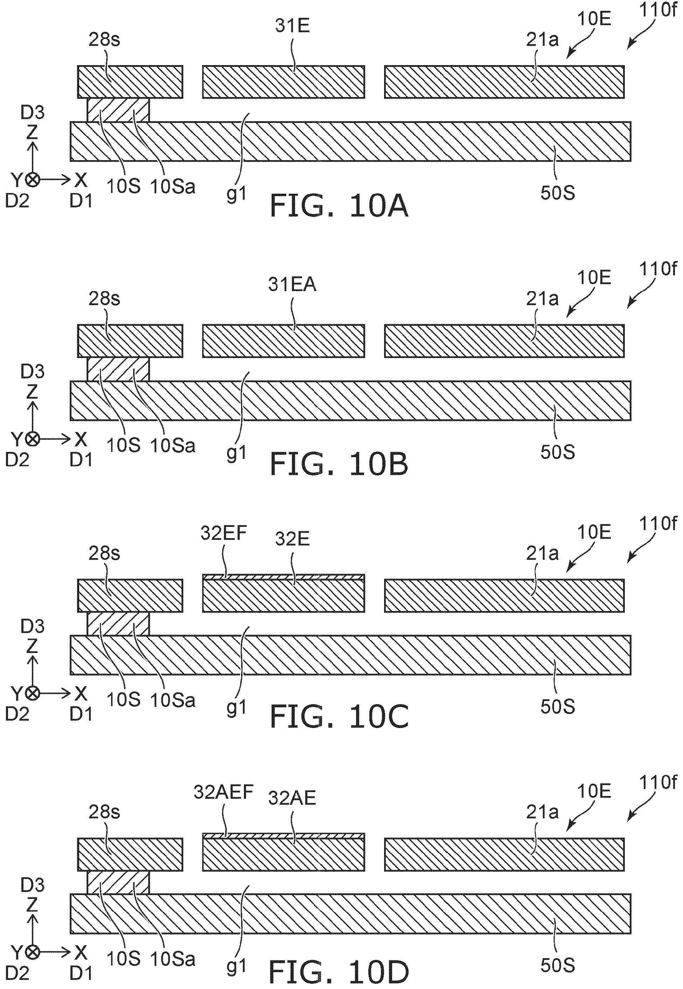

FIGS. 10A to 10D are schematic cross-sectional views illustrating the sensor according to the first embodiment.

FIGS. 10A to 10D are cross-sectional views corresponding to the lines A1-A2, A5-A6, A7-A8, and A11-A12 in FIG. 1.

In a sensor 110f according to the embodiment, a second layer structure of the second beam electrode 32E is different from a first layer structure of the first beam electrode 31E. In this example, the second beam electrode 32E includes a second beam layer 32EF and the first beam electrode 31E does not include the first beam layer. In the sensor 110f, a second opposing layer structure of the second opposing beam electrode 32AE is different from a first opposing layer structure of the first opposing beam electrode 31AE. In this example, the second opposing beam electrode 32AE includes a second opposing beam layer 32AEF, and the first opposing beam electrode 31AE does not include the first opposing beam layer. The two beams have different resonance characteristics (resonance frequencies). The second beam layer 32EF and the second opposing beam layer 32AEF may include, for example, a metal film.

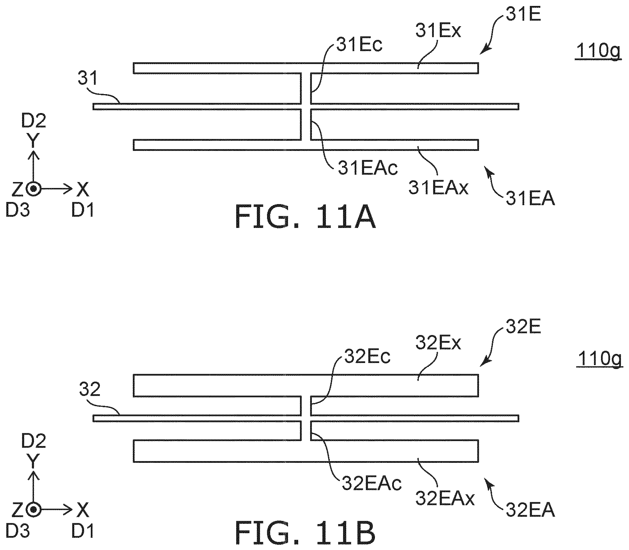

FIGS. 11A and 11B are schematic plan views illustrating a part of a sensor according to the first embodiment.

FIG. 11A illustrates a portion including the first beam 31. FIG. 11B illustrates a portion including the second beam 32.

In a sensor 110g according to the embodiment, a second shape of the second beam electrode 32E is different from a first shape of the first beam electrode 31E. In the sensor 110g, a second opposing shape of the second opposing beam electrode 32AE is different from a first opposing shape of the first opposing beam electrode 31AE. The two beams have different resonance characteristics (resonance frequencies). In this example, a ratio of a length of the second extending portion 32Ex in the second direction D2 to a length of the second extending portion 32Ex in the first direction D1 is higher than a ratio of a length of the first extending portion 31Ex in the second direction D2 to a length of the first extending portion 31Ex in the first direction D1. The difference in shape may include a difference between at least one of a protruding portion and a depression portion.

As described above, in the embodiment, the first beam electrode 31E and the second beam electrode 32E may satisfy at least one of a first condition, a second condition, a third condition, a fourth condition, a fifth condition, a sixth condition, a seventh condition or an eighth condition.

In the first condition, the second mass of the second beam electrode 32E is different from the first mass of the first beam electrode 31E. In the second condition, at least a part of the second material included in the second beam electrode 32E is different from at least a part of the first material included in the first beam electrode 31E. In the third condition, the second thickness t32E along the third direction D3 of the second beam electrode 32E is different from the first thickness t31E along the third direction D3 of the first beam electrode 31E. The third direction D3 crosses a plane including the first direction D1 and the second direction D2.

In the fourth condition, the second size of the second hole 32Eh included in the second beam electrode 32E is different from the first size of the first hole 31Eh included in the first beam electrode 31E. In the fifth condition, the second density of the second holes 32Eh is different from the first density of the first holes 31Eh.

In the sixth condition, the second number of second holes 32Eh is different from the first number of first holes 31Eh. Alternatively, in the sixth condition, the second beam electrode 32E includes the second hole 32Eh and the first beam electrode 31E does not include the first hole 31Eh.

In the seventh condition, the second layer structure of the second beam electrode 32E is different from the first layer structure of the first beam electrode 31E. In the eighth condition, the second shape of the second beam electrode 32E is different from the first shape of the first beam electrode 31E.

The first opposing beam electrode 31AE and the second opposing beam electrode 32AE may satisfy at least one of a ninth condition, a tenth condition, an eleventh condition, a twelfth condition, a thirteenth condition, a fourteenth condition, a fifteenth condition, or a sixteenth condition.

In the ninth condition, a second opposing mass of the second opposing beam electrode 32AE is different from a first opposing mass of the first opposing beam electrode 31AE. In the tenth condition, at least a part of a second opposing material included in the second opposing beam electrode 32AE is different from at least a part of a first opposing material included in the first opposing beam electrode 31AE. In the eleventh condition, a second opposing thickness t32AE along the third direction D3 of the second opposing beam electrode 32AE is different from a first opposing thickness t31AE along the third direction D3 of the first opposing beam electrode 31AE.

In the twelfth condition, the second opposing size of the second opposing hole 32AEh included in the second opposing beam electrode 32AE is different from the first opposing size of the first opposing hole 31AEh included in the first opposing beam electrode 31AE. In the thirteenth condition, the second opposing density of the second opposing holes 32AEh is different from the first opposing density of the first opposing holes 31AEh.

In the fourteenth condition, the second opposing number of the second opposing holes 32AEh is different from the first opposing number of the first opposing holes 31AEh. Alternatively, in the fourteenth condition, the second opposing beam electrode 32AE includes the second opposing hole 32AEh, and the first opposing beam electrode 31AE does not include the first opposing hole 31AEh.

In the fifteenth condition, the second opposing layer structure of the second opposing beam electrode 32AE is different from the first opposing layer structure of the first opposing beam electrode 31AE. In the sixteenth condition, the second opposing shape of the second opposing beam electrode 32AE is different from the first opposing shape of the first opposing beam electrode 31AE.

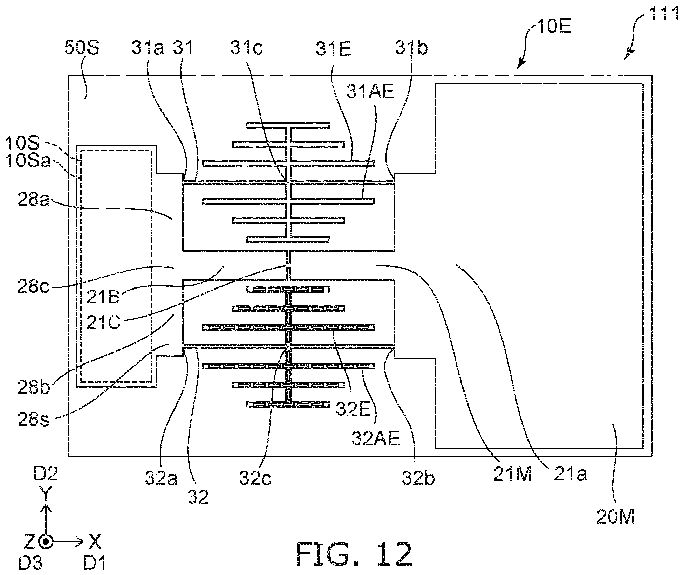

FIG. 12 is a schematic plan view illustrating a sensor according to the first embodiment.

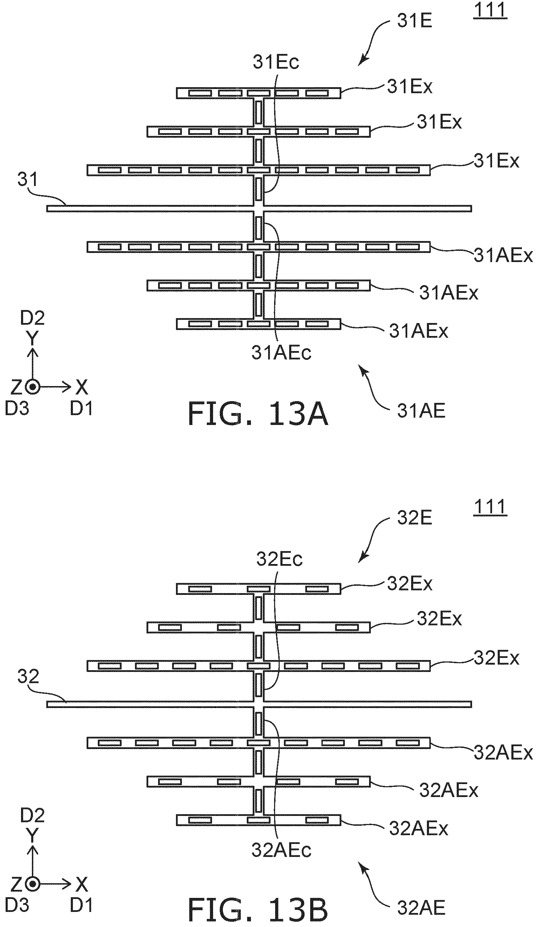

FIGS. 13A and 13B are schematic plan views illustrating the sensor according to the first embodiment.

As shown in FIG. 12, in a sensor 111 according to the embodiment, the shape of the first beam electrode 31E is different from the shape of the first beam electrode 31E in the sensor 110. In the sensor 111, the shape of the second beam electrodes 32E is different from the shape of the second beam electrodes 32E in the sensor 110. Except for this, the configuration of the sensor 111 may be the same as the configuration of the sensor 110. In FIG. 12, fixed electrodes are omitted.

As shown in FIG. 13A, in the sensor 111, the first beam electrode 31E includes a plurality of first extending portions 31Ex. One of the plurality of first extending portions 31Ex is provided between the first beam 31 and another one of the plurality of first extending portions 31Ex. For example, a length of the one of the plurality of first extending portions 31Ex along the first direction D1 is longer than a length of the other one of the plurality of first extending portions 31Ex along the first direction D1. By providing the plurality of first extending portions 31Ex, for example, the vibration of the first beam 31 can be effectively controlled with high accuracy.

As shown in FIG. 13B, in the sensor 111, the second beam electrode 32E includes a plurality of second extending portions 32Ex. One of the plurality of second extending portions 32Ex is provided between the second beam 32 and another one of the plurality of second extending portions 32Ex. For example, a length of the one of the plurality of second extending portions 32Ex along the first direction D1 is longer than a length of the other one of the plurality of second extending portions 32Ex along the first direction D1. By providing the plurality of second extending portions 32Ex, for example, the vibration of the second beam 32 can be effectively controlled with high accuracy.

As shown in FIG. 13A, in the sensor 111, the first opposing beam electrode 31AE includes a plurality of first opposing extending portions 31AEx. One of the plurality of first opposing extending portions 31AEx is provided between the first beam 31 and another one of the plurality of first opposing extending portions 31AEx. For example, a length of the one of the plurality of first opposing extending portions 31AEx along the first direction D1 is longer than a length of the other one of the plurality of first opposing extending portions 31AEx along the first direction D1. By providing the plurality of first opposing extending portions 31AEx, for example, the vibration characteristics of the first beam 31 can be effectively detected with high accuracy.

As shown in FIG. 13B, in the sensor 111, the second opposing beam electrode 32AE includes a plurality of second opposing extending portions 32AEx. One of the plurality of second opposing extending portions 32AEx is provided between the second beam 32 and another one of the plurality of second opposing extending portions 32AEx. For example, a length of the plurality of second opposing extending portions 32AEx along the first direction D1 is longer than a length of the other one of the plurality of second opposing extending portions 32AEx along the first direction D1. By providing the plurality of second opposing extending portions 32AEx, for example, the vibration characteristics of the second beam 32 can be effectively detected with high accuracy.

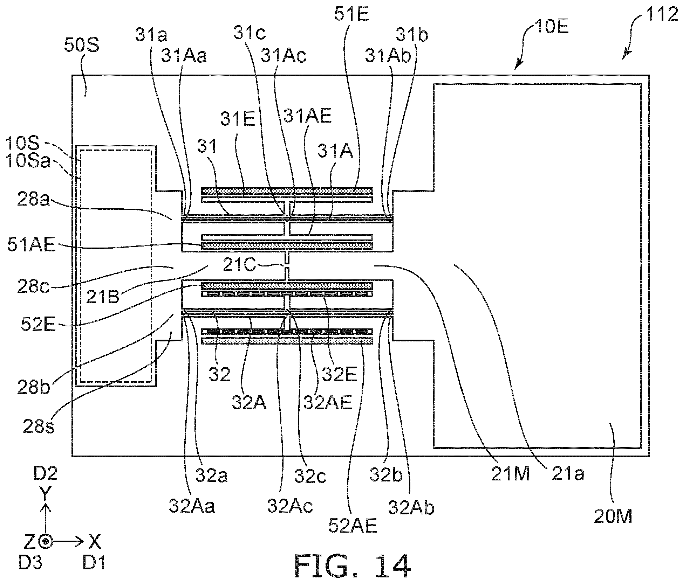

FIG. 14 is a schematic plan view illustrating a sensor according to the first embodiment.

As shown in FIG. 14, in a sensor 112 according to the embodiment, the element section 10E includes the first opposing beam 31A and the second opposing beam 32A. Except for this, the configuration of the sensor 112 may be the same as the configuration of the sensor 110.

In the sensor 112, the first opposing beam 31A includes a first opposing portion 31Aa, a first other opposing portion 31Ab, and a first opposing intermediate portion 31Ac. The first opposing intermediate portion 31Ac is provided between the first opposing portion 31Aa and the first other opposing portion 31Ab. A direction from the first opposing portion 31Aa to the first other opposing portion 31Ab is along the first direction D1. The first opposing beam electrode 31AE is connected to the first opposing intermediate portion 31Ac.

The second opposing beam 32A includes a second opposing portion 32Aa, a second other opposing portion 32Ab, and a second opposing intermediate portion 32Ac. The second opposing intermediate portion 32Ac is provided between the second opposing portion 32Aa and the second other opposing portion 32Ab. A direction from the second opposing portion 32Aa to the second other opposing portion 32Ab is along the first direction D1. The second opposing beam electrode 32AE is connected to the second opposing intermediate portion 32Ac.

In the sensor 112, for example, detection with high accuracy and wide dynamic range is possible. A sensor capable of improving characteristics can be provided.

The first extending connecting portion 31Ec connects the first extending portion 31Ex to the first intermediate portion 31c. The second extending connecting portion 32Ec connects the second extending portion 32Ex to the second intermediate portion 32c. The first opposing extending connecting portion 31AEc connects the first opposing extending portion 31AEx to the first opposing intermediate portion 31Ac. The second opposing extending connecting portion 32AEc connects the second opposing extending portion 32AEx to the second opposing intermediate portion 32Ac.

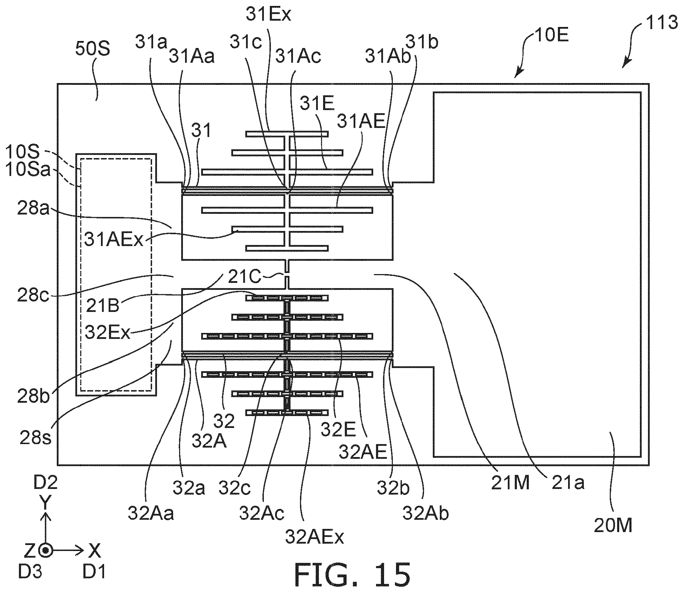

FIG. 15 is a schematic plan view illustrating a sensor according to the first embodiment.

As shown in FIG. 15, in a sensor 113 according to the embodiment, the plurality of first extending portions 31Ex, the plurality of second extending portions 32Ex, the plurality of first opposing extending portions 31AEx, and the plurality of second opposing extending portions 31AEx. Except for this, the configuration of the sensor 113 may be the same as the configuration of the sensor 112.

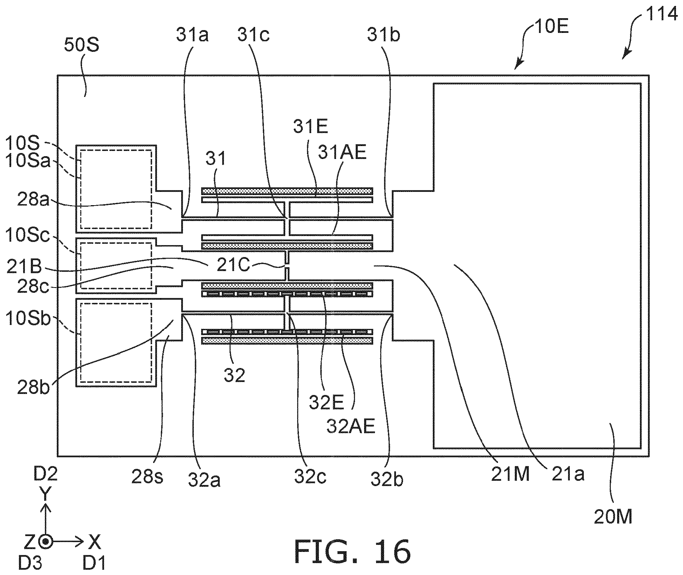

FIG. 16 is a schematic plan view illustrating the sensor according to the first embodiment.

As shown in FIG. 16, in a sensor 114 according to the embodiment, the first fixed portion 10S includes the first fixed region 10Sa, the second fixed region 10Sb, and the third fixed region 10Sc. Except for this, the configuration of the sensor 114 may be the same as the configuration of the sensor 110.

In the sensor 114, the first support region 28a is supported by first fixed region 10Sa. The second support region 28b is supported by the second fixed region 10Sb. The third support region 28c is supported by the third fixed region 10Sc.

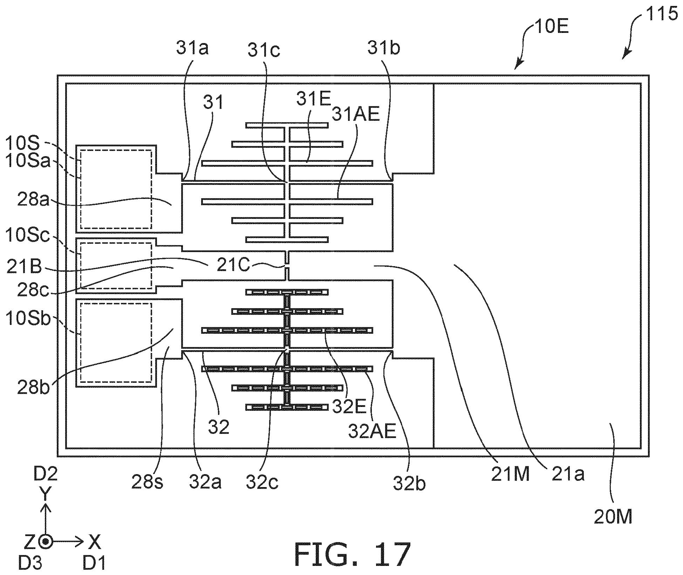

FIG. 17 is a schematic plan view illustrating a sensor according to the first embodiment.

As shown in FIG. 17, in a sensor 115 according to the embodiment, the first fixed portion 10S includes the first fixed region 10Sa, the second fixed region 10Sb, and the third fixed region 10Sc. Except for this, the configuration of the sensor 115 may be the same as the configuration of the sensor 111 or the sensor 114.

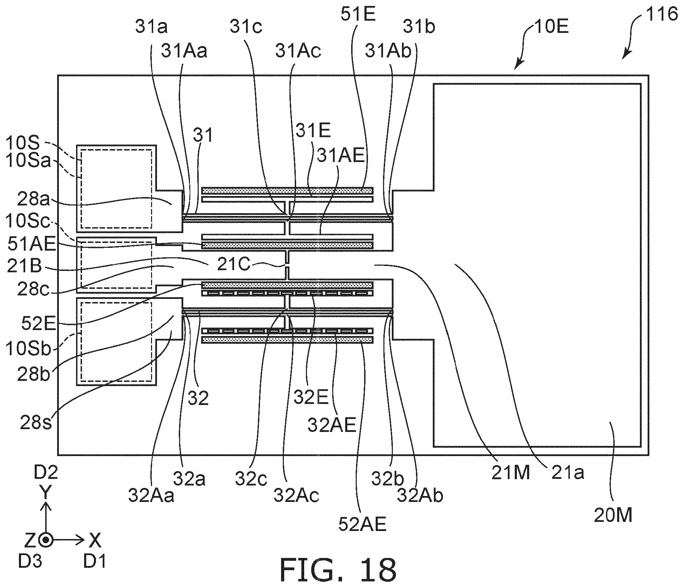

FIG. 18 is a schematic plan view illustrating a sensor according to the first embodiment.

As shown in FIG. 18, in a sensor 116 according to the embodiment, the first fixed portion 10S includes the first fixed region 10Sa, the second fixed region 10Sb, and the third fixed region 10Sc. Except for this, the configuration of sensor 116 may be the same as the configuration of sensor 112 or sensor 114.

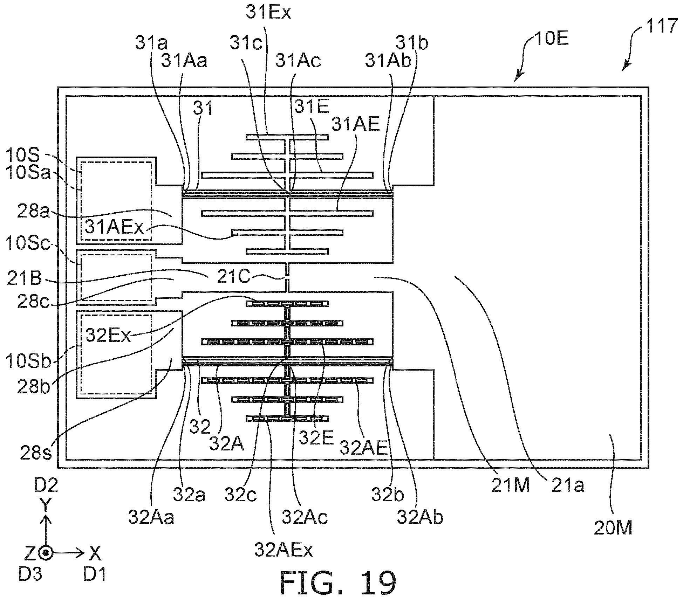

FIG. 19 is a schematic plan view illustrating a sensor according to the first embodiment.

As shown in FIG. 19, in a sensor 117 according to the embodiment, the first fixed portion 10S includes the first fixed region 10Sa, the second fixed region 10Sb, and the third fixed region 10Sc. Except for this, the configuration of the sensor 116 may be the same as the configuration of the sensor 113 or the sensor 114.

In the sensors 113-117, for example, detection with high accuracy and a wide dynamic range is possible. A sensor capable of improving characteristics can be provided.

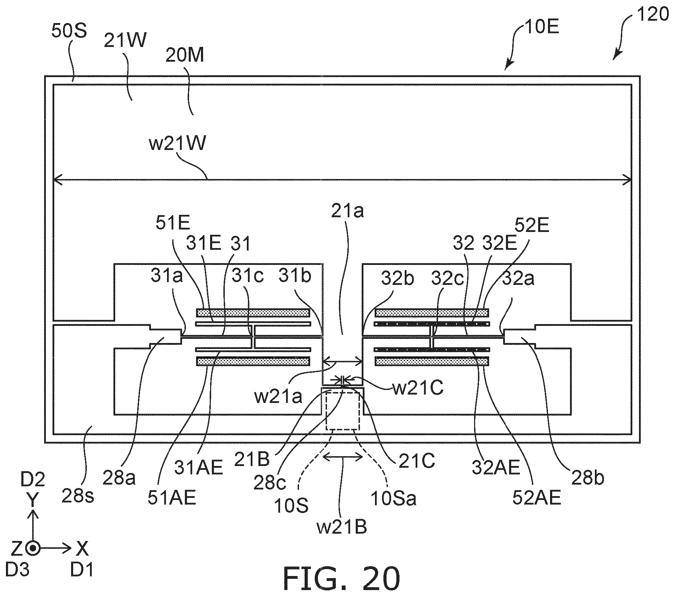

FIG. 20 is a schematic plan view illustrating a sensor according to the first embodiment.

As shown in FIG. 20, in a sensor 120 according to the embodiment, the configurations of the first beam 31 and the second beam 32 are different from those configurations in the sensor 110. Except for this, the configuration of the sensor 120 may be the same as the configuration of the sensor 110.

In the sensor 120, the position of the first other portion 31b in the first direction D1 is provided between the position of the first portion 31a in the first direction D1 and the position of the second portion 32a in the first direction D1. The position of the second other portion 32b in the first direction D1 is provided between the position of the first other portion 31b in the first direction D1 and the position of the second portion 32a in the second direction D2.

In the sensor 120, the element section 10E includes the movable member 20M. The movable member 20M is supported by the first fixed portion 10S. The movable member 20M includes the first movable portion 21a. The first other portion 31b and the second other portion 32b are connected to the first movable portion 21a. For example, in the first direction D1, the first movable portion 21a is provided between the first other portion 31b and the second other portion 32b.

The first support portion 28s includes the first support region 28a, the second support region 28b, and the third support region 28c. The first portion 31a is supported by the first support region 28a. The second portion 32a is supported by the second support region 28b. The first movable portion 21a is supported by the third support region 28c.

In this example, the movable member 20M includes the first movable base portion 21B supported by the third support region 28c, and the first movable connecting portion 21C provided between the first movable base portion 21B and the first movable portion 21a.

The first movable connecting portion width w21C of the first movable connecting portion 21C in the first direction D1 is narrower than the first movable base width w21B of the first movable base portion 21B in the first direction D1. The first movable connecting portion width w21C is narrower than the first movable portion width w21a of the first movable portion 21a in the first direction D1. The first movable connecting portion 21C function as a pivot part, for example. The applied force is amplified. The two beams are effectively stressed. Effectively, the resonance characteristics (e.g., resonance frequency) are changed in the two beams.

In this example, the movable member 20M further includes a first movable weight portion 21W connected to the first movable portion 21a. The first movable portion 21a is provided between the first movable connecting portion 21C and the first movable weight portion 21W in the second direction D2. A first movable weight portion width w21W in the first direction D1 of the first movable weight portion 21W is wider than the first movable portion width w21a. A larger stress is applied to the two beams by the first movable weight portion 21W.

In the sensor 120, the element section 10E is provided with the first beam electrode 31E and the second beam electrode 32E. The element section 10E may include the first opposing beam electrode 31AE and the second opposing beam electrode 32AE. The first opposing beam electrode 31AE is connected to the first intermediate portion 31c. The second opposing beam electrode 32AE is connected to the second intermediate portion 32c. The first beam 31 is provided between the first opposing beam electrode 31AE and the first beam electrode 31E in the second direction D2. The second beam 32 is provided between the second opposing beam electrode 32AE and the second beam electrode 32E in the second direction D2.

In the sensor 120, at least any one of the first to eighth conditions described above may be applied. In the sensor 120, at least one of the ninth to sixteenth conditions described above may be applied. In the sensor 120, for example, detection with high accuracy and a wide dynamic range is possible. A sensor capable of improving characteristics can be provided.

Also in the sensor 120, the first beam electrode 31E includes the first extending portion 31Ex and the first extending connecting portion 31Ec (see FIG. 11A). The second beam electrode 32E includes the second extending portion 32Ex and the second extending connecting portion 32Ec (see FIG. 11B). The first opposing beam electrode 31AE includes the first opposing extending portion 31AEx and the first opposing extending connecting portion 31AEc (see FIG. 11A). The second opposing beam electrode 32AE includes the second opposing extending portion 32AEx and the second opposing extending connecting portion 32AEc (see FIG. 11B).

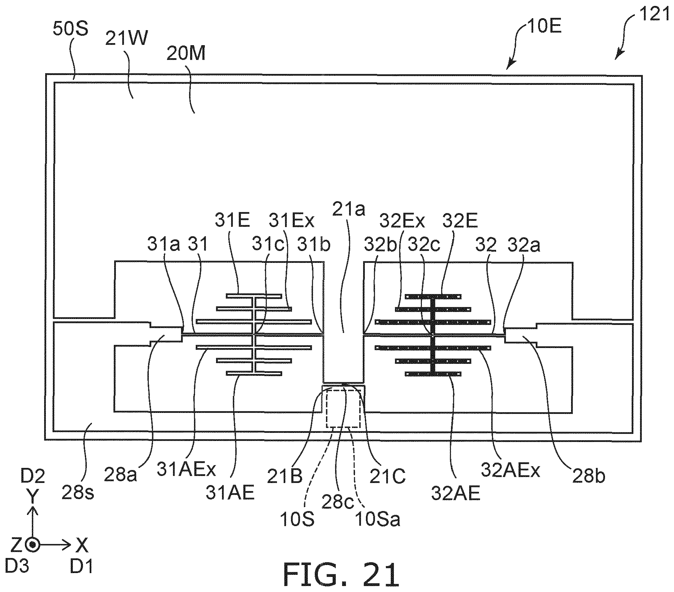

FIG. 21 is a schematic plan view illustrating a sensor according to the first embodiment.

As shown in FIG. 21, in a sensor 121 according to the embodiment, the element section 10E includes the plurality of first extending portions 31Ex, the plurality of second extending portions 32Ex, the plurality of first opposing extending portions 31AEx, and the plurality of second opposing extending portions 32AEx. Except for this, the configuration of the sensor 121 may be the same as the configuration of the sensor 120.

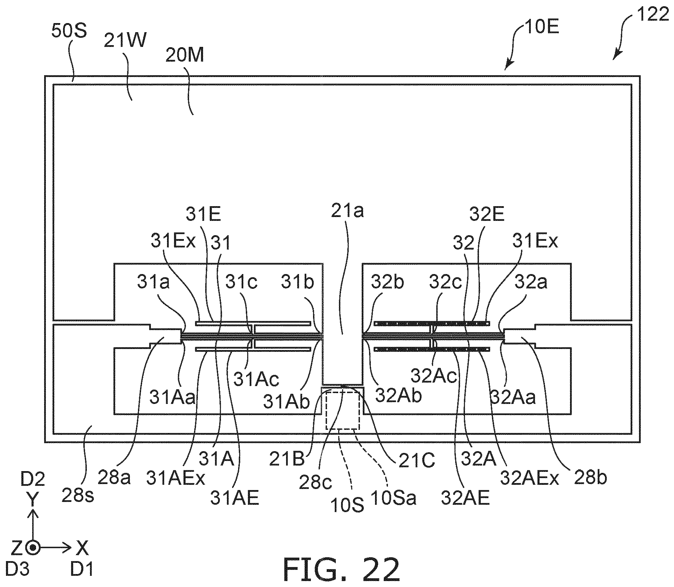

FIG. 22 is a schematic plan view illustrating a sensor according to the first embodiment.

As shown in FIG. 22, in the sensor 122 according to the embodiment, the first opposing beam 31A and the second opposing beam 32A are provided. Except for this, the configuration of the sensor 122 may be the same as the configuration of the sensor 120.

In the sensor 122, the element section 10E includes the first opposing beam 31A, the first opposing beam electrode 31AE, the second opposing beam 32A, and the second opposing beam electrode 32AE. As already explained, the first opposing beam 31A includes the first opposing portion 31Aa, the first other opposing portion 31Ab, and the first opposing intermediate portion 31Ac. The direction from the first opposing portion 31Aa to the first other opposing portion 31Ab is along the first direction D1. The first opposing beam electrode 31AE is connected to the first opposing intermediate portion 31Ac.

The second opposing beam 32A includes the second opposing portion 32Aa, the second other opposing portion 32Ab, and the second opposing intermediate portion 32Ac. The direction from the second opposing portion 32Aa to the second other opposing portion 32Ab is along the first direction D1. The second opposing beam electrode 32AE is connected to the second opposing intermediate portion 32Ac.

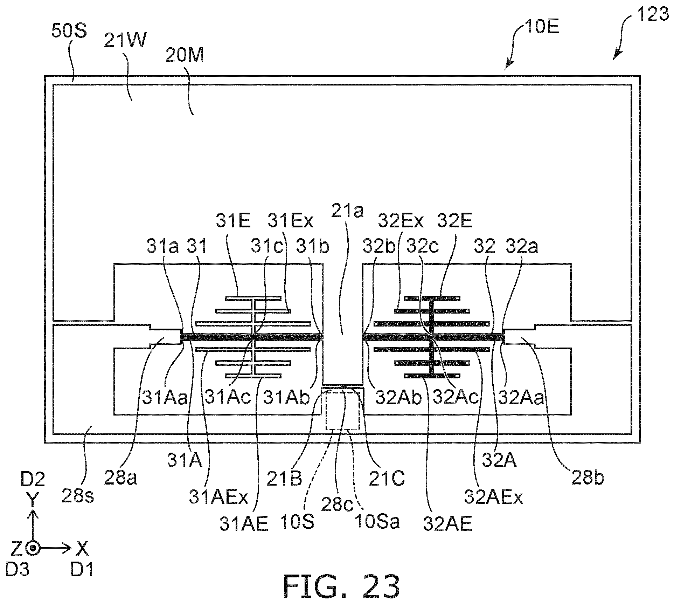

FIG. 23 is a schematic plan view illustrating a sensor according to the first embodiment.

As shown in FIG. 23, in a sensor 123 according to the embodiment, the element section 10E includes the plurality of first extending portions 31Ex, the plurality of second extending portions 32Ex, the plurality of first opposing extending portions 31AEx, and the plurality of second opposing extending portions 32AEx. Except for this, the configuration of the sensor 123 may be the same as the configuration of the sensor 122.

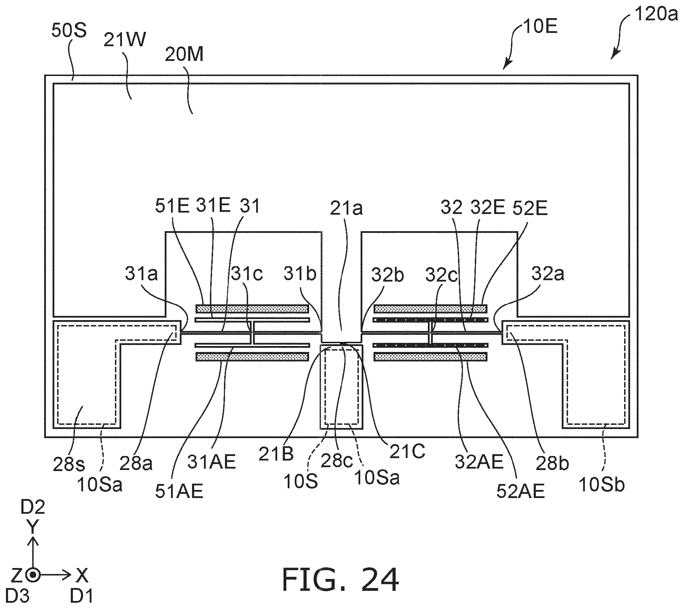

FIG. 24 is a schematic plan view illustrating a sensor according to the first embodiment.

As shown in FIG. 24, in a sensor 120a according to the embodiment, the first fixed portion 10S includes the first fixed region 10Sa, the second fixed region 10Sb, and the third fixed region 10Sc. Except for this, the configuration of the sensor 120a may be the same as the configuration of the sensor 120.

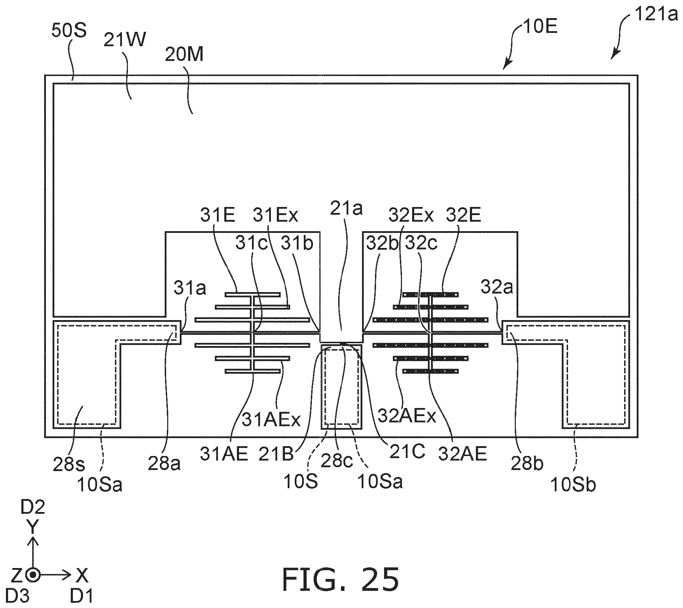

FIG. 25 is a schematic plan view illustrating a sensor according to the first embodiment.

As shown in FIG. 25, in a sensor 121a according to the embodiment, the first fixed portion 10S includes the first fixed region 10Sa, the second fixed region 10Sb, and the third fixed region 10Sc. Except for this, the configuration of the sensor 121a may be the same as the configuration of the sensor 121.

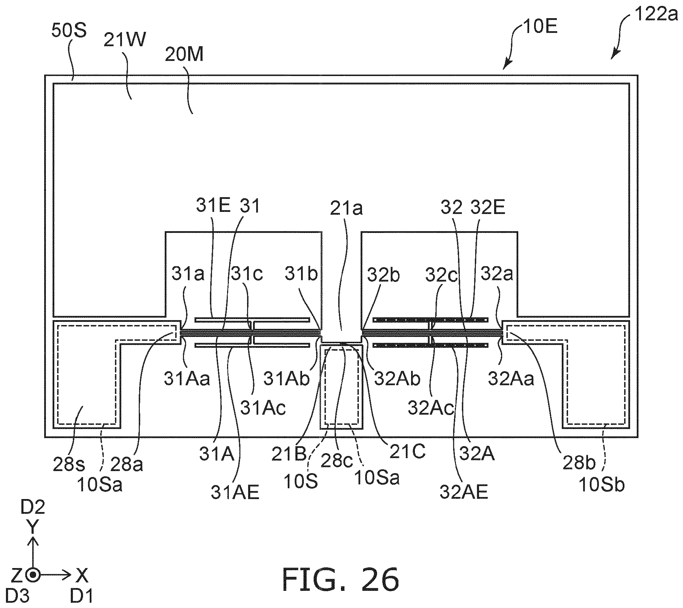

FIG. 26 is a schematic plan view illustrating a sensor according to the first embodiment.

As shown in FIG. 26, in a sensor 122a according to the embodiment, the first fixed portion 10S includes the first fixed region 10Sa, the second fixed region 10Sb, and the third fixed region 10Sc. Except for this, the configuration of the sensor 122a may be the same as the configuration of the sensor 122.

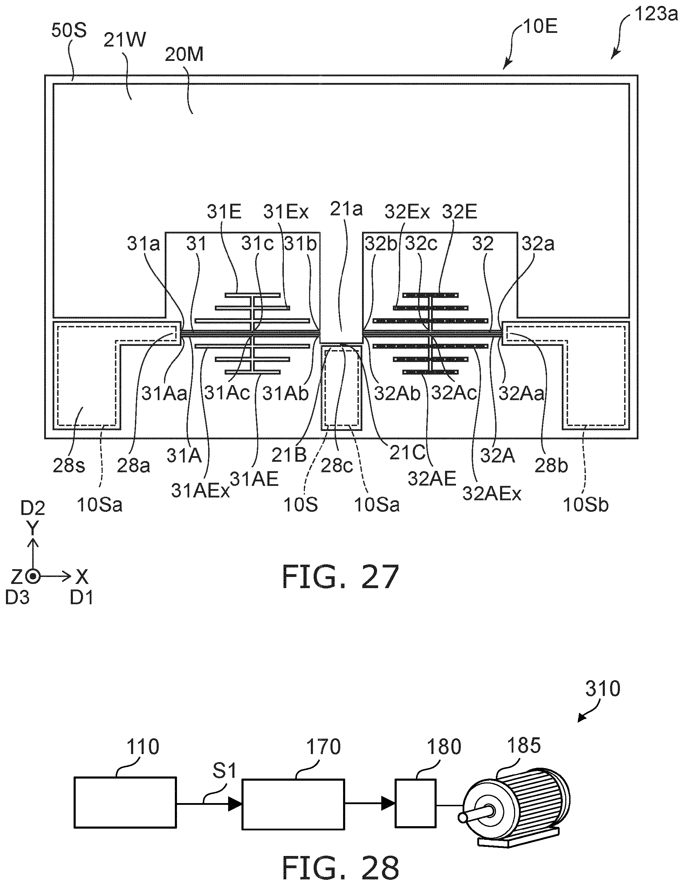

FIG. 27 is a schematic plan view illustrating a sensor according to the first embodiment.

As shown in FIG. 27, in a sensor 123a according to the embodiment, the first fixed portion 10S includes the first fixed region 10Sa, the second fixed region 10Sb, and the third fixed region 10Sc. Except for this, the configuration of the sensor 123a may be the same as the configuration of the sensor 123.

In the sensors 121 to 123 and the sensors 120a to 123a, for example, detection with high accuracy and a wide dynamic range is possible. A sensor capable of improving characteristics can be provided.

### Second Embodiment

The second embodiment relates to an electronic device.

FIG. 28 is a schematic diagram illustrating an electronic device according to the second embodiment.

As shown in FIG. 28, an electronic device 310 according to the embodiment includes the sensor according to the first embodiment and a circuit controller 170. In the example of FIG. 28, the sensor 110 is drawn as the sensor. The circuit controller 170 is configured to control a circuit 180 based on a signal S1 obtained from the sensor. The circuit 180 is, for example, a control circuit of a driving device 185 or the like. According to the embodiment, for example, the circuit 180 for controlling the driving device 185 can be controlled with high accuracy.

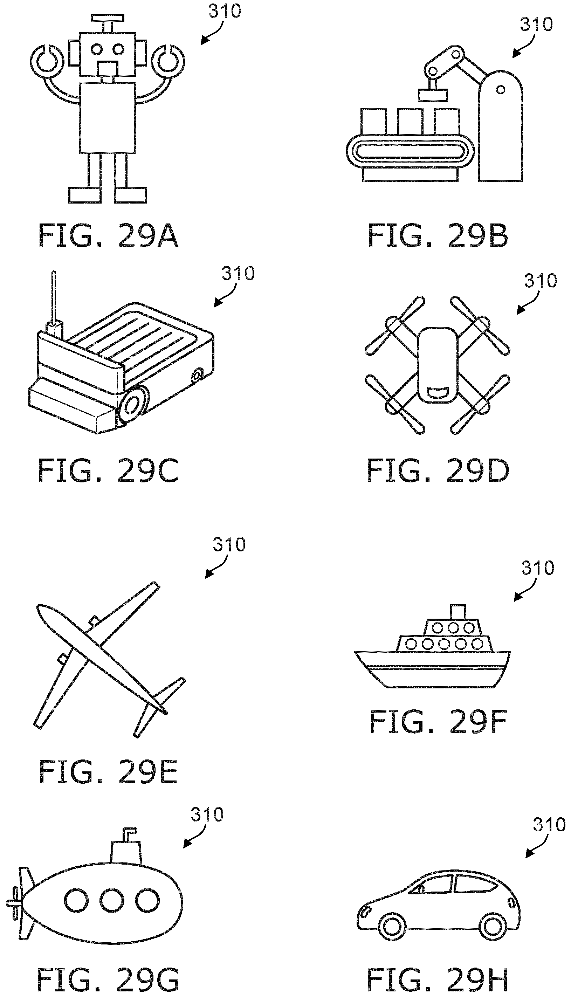

FIGS. 29A to 29H are schematic diagrams illustrating applications of the electronic device according to the embodiment.

As shown in FIG. 29A, the electronic device 310 may be at least a part of a robot. As shown in FIG. 29B, the electronic device 310 may be at least a part of a work robot provided in a manufacturing factory or the like. As shown in FIG. 29C, the electronic device 310 may be at least a part of an automated guided vehicle such as in a factory. As shown in FIG. 29D, the electronic device 310 may be at least a part of a drone (unmanned aerial vehicle). As shown in FIG. 29E, the electronic device 310 may be at least a part of an airplane. As shown in FIG. 29F, the electronic device 310 may be at least a part of a vessel. As shown in FIG. 29G, the electronic device 310 may be at least a part of a submarine. As shown in FIG. 29H, the electronic device 310 may be at least a part of an automobile. The electronic device 310 may include, for example, at least one of a robot or a mobile object.

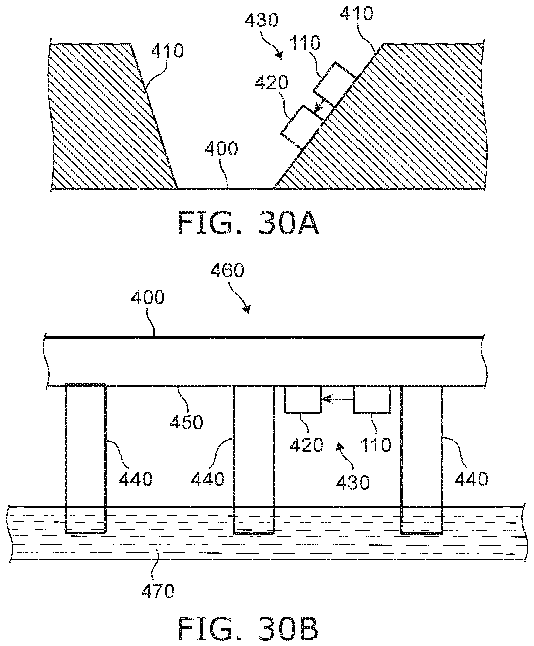

FIGS. 30A and 30B are schematic diagrams illustrating applications of the sensor according to the embodiment.

As shown in FIG. 30A, a sensor 430 according to the embodiment includes the sensor according to the first embodiment and a transmitter/receiver 420. In the example of FIG. 30A, the sensor 110 is drawn as the sensor. The transmitter/receiver 420 is configured to transmit the signal obtained from the sensor 110 by at least one of wireless or wired methods, for example. The sensor 430 is provided, for example, on a slope surface 410 such as a road 400. The sensor 430 may, for example, monitor conditions such as facilities (e.g., infrastructure). The sensor 430 may be, for example, a condition monitoring device.

For example, the sensor 430 detects changes in the state of the slope surface 410 of the road 400 with high accuracy. A change in the state of the slope surface 410 includes, for example, at least one of a change in tilt angle or a change in vibration state. The signal (test result) obtained from the sensor 110 is transmitted by the transmitter/receiver 420. The condition of facilities (e.g., infrastructure) can be monitored, e.g., continuously.

As shown in FIG. 30B, the sensor 430 is provided on a part of a bridge 460, for example. The bridge 460 is provided over a river 470. For example, the bridge 460 includes at least one of main girder 450 and a bridge pier 440. The sensor 430 is provided on at least one of the main girder 450 and the bridge pier 440. For example, the angle of at least one of the main girder 450 and the bridge pier 440 may change due to deterioration or the like. For example, in at least one of the main girder 450 and the bridge pier 440, the vibration state may change. The sensor 430 detects these changes with high accuracy. A detection result can be transmitted to an arbitrary place by the transmitter/receiver 420. Anomalies can be effectively detected.

According to the embodiments, a sensor and an electronic devices capable of enhanced properties can be provided.

Hereinabove, exemplary embodiments of the invention are described with reference to specific examples. However, the embodiments of the invention are not limited to these specific examples. For example, one skilled in the art may similarly practice the invention by appropriately selecting specific configurations of components included in sensors such as bases, support portions, element sections, controllers, etc., from known art. Such practice is included in the scope of the invention as defined by the accompanying claims.

Further, any two or more components of the specific examples may be combined within the extent of technical feasibility and are included in the scope of the invention as defined by the accompanying claims.

Moreover, all sensors and electronic devices practicable by an appropriate design modification by one skilled in the art based on the sensors and the electronic devices described above as embodiments of the invention also are within the scope of the invention as defined by the accompanying claims.

Various other variations and modifications can be conceived by those skilled in the art, and it is understood that such variations and modifications are also encompassed within the scope of the invention as defined by the accompanying claims.

While certain embodiments have been described, these embodiments have been presented by way of example only, and are not intended to limit the scope of the inventions, which is defined by the accompanying claims. Indeed, the novel embodiments described herein may be embodied in a variety of other forms; furthermore, various omissions, substitutions and changes in the form of the embodiments described herein may be made without departing from the scope of the inventions as defined by the accompanying claims.

## Claims

1. A sensor (110-110g, 111-117, 120-123a), comprising:
a base (50S);
a first fixed portion (10S) fixed to the base (50S);
an element section (10E), a first gap being provided between the base (50S) and the element section (10E), the element section (10E) including
a first support portion (28s) supported by the first fixed portion (10S),
a first beam (31) including a first portion (31a) connected to the first support portion (28s), a first other portion (31b), and a first intermediate portion (31c) between the first portion (31a) and the first other portion (31b), a direction from the first portion (31a) to the first other portion (31b) being along a first direction,
a first beam electrode (31E) connected to the first intermediate portion (31c),
a first opposing beam electrode (31AE) connected to the first intermediate portion (31c),
a second beam (32) including a second portion (32a) connected to the first support portion (28s), a second other portion (32b), and a second intermediate portion (32c) between the second portion (32a) and the second other portion (32b), a direction from the second portion (32a) to the second other portion (32b) being along the first direction,
a second beam electrode (32E) connected to the second intermediate portion (32c), and
a second opposing beam electrode (32AE) connected to the second intermediate portion (32c),
a second direction from the first intermediate portion (31c) to the first beam electrode (31E) crossing the first direction,
a direction from the second intermediate portion (32c) to the second beam electrode (32E) being along the second direction,
a direction from the second beam (32) to the first beam (31) being along the second direction,
the first beam (31) being provided between the first opposing beam electrode (31AE) and the first beam electrode (31E) in the second direction,
the second beam (32) being provided between the second opposing beam electrode (32AE) and the second beam electrode (32E) in the second direction, and
the first beam electrode (31E) and the second beam electrode (32E) satisfying at least one of a first condition, a second condition, a third condition, a fourth condition, a fifth condition, a sixth condition, a seventh condition or an eighth condition,
in the first condition, a second mass of the second beam electrode (32E) being different from a first mass of the first beam electrode (31E),
in the second condition, at least a part of a second material included in the second beam electrode (32E) being different from at least a part of a first material included in the first beam electrode (31E),
in the third condition, a second thickness of the second beam electrode (32E) along a third direction being different from a first thickness of the first beam electrode (31E) along the third direction, the third direction crossing a plane including the first direction and the second direction, a direction from the base (50S) to the first fixed portion (10S) being along the third direction,
in the fourth condition, a second size of a second hole (32Eh) included in the second beam electrode (32E) being different from a first size of a first hole (31Eh) included in the first beam electrode (31E),
in the fifth condition, a second density of the second holes (32Eh) being different from the first density of the first holes (31Eh),
in the sixth condition, a second number of the second holes (32Eh) being different from a first number of the first holes (31Eh), or the second beam electrode (32E) including the second holes (32Eh) and the first beam electrode (31E) not including the first hole (31Eh),
in the seventh condition, a second layer structure of the second beam electrode (32E) being different from a first layer structure of the first beam electrode (31E), and
in the eighth condition, a second shape of the second beam electrode (32E) being different from a first shape of the first beam electrode (31E), and wherein
the element section (10E) further includes a movable member (20M) supported by the first fixed portion (10S),
the movable member (20M) includes a first movable portion (21a), and
the first other portion (31b) and the second other portion (32b) are connected to the first movable portion (21a),
the sensor (110-110g, 111-117, 120-123a) further comprising
a first fixed electrode (51E) and a second fixed electrode (52E) fixed to the base,
the second fixed electrode (52E) facing the second beam electrode (32E).

2. The sensor (110-110g, 111-117, 120-123a) according to claim 1, wherein
the movable member (20M) further includes
a first movable base portion (21B) supported by the first fixed portion (10S),
a first movable intermediate portion (21M) provided between the first movable base portion (21B) and the first movable portion (21a), and
a first movable connecting portion (21C) provided between the first movable base portion (21B) and the first movable intermediate portion (21M),
a first movable connecting portion width of the first movable connecting portion (21C) in the second direction is narrower than a first movable base portion width of the first movable base portion (21B) in the second direction, and
the first movable connecting portion width is narrower than a first movable intermediate portion width of the first movable intermediate portion (21M) in the second direction.

3. The sensor (110-110g, 111-117, 120-123a) according to any one of claims 1-2, wherein
the first beam electrode (31E) includes
a first extending portion (31Ex) extending along the first direction, and
a first extending connecting portion (31Ec) connecting the first extending portion (31Ex) to the first intermediate portion (31c), and
the second beam electrode (32E) includes
a second extending portion (32Ex) along the first direction, and
a second extending connecting portion (32Ec) connecting the second extending portion (32Ex) to the second intermediate portion (32c).

4. The sensor (110-110g, 111-117, 120-123a) according to claim 1, wherein
the first opposing beam electrode (31AE) and the second opposing beam electrode (32AE) satisfy at least one of a ninth condition, a tenth condition, an eleventh condition, a twelfth condition, a thirteenth condition, a fourteenth condition, a fifteenth condition or a sixteenth condition,
in the ninth condition, a second opposing mass of the second opposing beam electrode (32AE) is different from the first opposing mass of the first opposing beam electrode (31AE),
in the tenth condition, at least a part of a second opposing material included in the second opposing beam electrode (32AE) is different from at least a part of a first opposing material included in the first opposing beam electrode (31AE),
in the eleventh condition, a second opposing thickness along the third direction of the second opposing beam electrode (32AE) is different from a first opposing thickness along the third direction of the first opposing beam electrode (31AE),
in the twelfth condition, a second opposing size of a second opposing hole (32AEh) included in the second opposing beam electrode (32AE) is different from a first opposing size of a first opposing hole (31AEh) included in the first opposing beam electrode (31AE),
in the thirteenth condition, a second opposing density of the second opposing holes (32AEh) is different from a first opposing density of the first opposing holes (31AEh),
in the fourteenth condition, a second opposing number of the second opposing holes (32AEh) is different from a first opposing number of the first opposing holes (31AEh), or the second opposing beam electrode (32AE) includes the second opposing hole (32AEh) and the first opposing beam electrode (31AE) does not include the first opposing hole (31AEh),
in the fifteenth condition, a second opposing layer structure of the second opposing beam electrode (32AE) is different from a first opposing layer structure of the first opposing beam electrode (31AE), and
in the sixteenth condition, a second opposing shape of the second opposing beam electrode (32AE) is different from a first opposing shape of the first opposing beam electrode (31AE).

5. The sensor (120-123a) according to claim 1, wherein
a position of the first other portion (31b) in the first direction is provided between a position of the first portion (31a) in the first direction and a position of the second portion (32a) in the first direction, and
a position of the second other portion (32b) in the first direction is provided between the position of the first other portion (31b) in the first direction and the position of the second portion (32a) in the second direction.

6. The sensor (120-123a) according to claim 5, wherein
the element section (10E) further includes a movable member (20M) supported by the first fixed portion (10S),
the movable member (20M) includes a first movable portion (21a),
the first other portion (31b) and the second other portion (32b) are connected to the first movable portion (21a),
the first support portion (28s) includes a first support region (28a), a second support region (28b), and a third support region (28c),
the first portion (31a) is supported by the first support region (28a),
the second portion (32a) is supported by the second support region (28b), and
the first movable portion (21a) is supported by the third support region (28c).

7. The sensor (120-123a) according to claim 6, wherein
the movable member (20M) further includes
a first movable base portion (21B) supported by the third support region (28c), and
a first movable connecting portion (21C) provided between the first movable base portion (21B) and the first movable portion (21a),
a first movable connecting portion width of the first movable connecting portion (21C) in the first direction is narrower than a first movable base width of the first movable base portion (21B) in the first direction, and
a first movable connecting portion width is narrower than a first movable portion width of the first movable portion (21a) in the first direction.

8. The sensor (120-123a) according to claim 7, wherein
the movable member (20M) further includes a first movable weight portion (21W) connected to the first movable portion (21a),
the first movable portion (21a) is provided between the first movable connecting portion (21C) and the first movable weight portion (21W) in the second direction, and
a first movable weight portion width in the first direction of the first movable weight portion (21W) is wider than the first movable portion width.

9. The sensor (120-123a) according to any one of claims 5-8,
wherein
the first beam electrode (31E) includes
a first extending portion (31Ex) extending along the first direction, and
a first extending connecting portion (31Ec) connecting the first extending portion (31Ex) to the first intermediate portion (31c),
the second beam electrode (32E) includes
a second extending portion (32Ex) extending along the second direction, and
a second extending connecting portion (32Ec) connecting the second extending portion (32Ex) to the second intermediate portion (32c).

10. The sensor (110-110g, 111-117, 120-123a) according to any one of claims 1-9, further comprising:
a controller (70);
the controller (70) being configured to apply a first AC signal between the first fixed electrode (51E) and the first beam electrode (31E), and
the controller (70) being configured to apply the first AC signal between the second fixed electrode (52E) and the second beam electrode (32E).

11. An electronic device (310), comprising:
the sensor (110-110g, 111-117, 120-123a) according to any one of claims 1-10; and
a circuit controller (170) configured to control a circuit (180) based on a signal obtained from the sensor (110-110g, 111-117, 120-123a).

## Patentansprüche

1. Sensor (110-110g, 111-117, 120-123a), umfassend:
eine Basis (50S);
einen ersten festen Abschnitt (10S), der an der Basis (50S) befestigt ist;
ein Elementsegment (10E), wobei zwischen der Basis (50S) und dem Elementsegment (10E) ein erster Spalt bereitgestellt ist, wobei das Elementsegment (10E) beinhaltet
einen ersten Stützabschnitt (28s), der von dem ersten festen Abschnitt (10S) gestützt wird,
einen ersten Strahl (31), der einen ersten Abschnitt (31a), der mit dem ersten Stützabschnitt (28s) verbunden ist, einen ersten anderen Abschnitt (31b) und einen ersten Zwischenabschnitt (31c) zwischen dem ersten Abschnitt (31a) und dem ersten anderen Abschnitt (31b) beinhaltet, wobei eine Richtung vom ersten Abschnitt (31a) zum ersten anderen Abschnitt (31b) entlang einer ersten Richtung verläuft,
eine erste Strahlelektrode (31E), die mit dem ersten Zwischenabschnitt (31c) verbunden ist,
eine erste Gegenstrahlelektrode (31AE), die mit dem ersten Zwischenabschnitt (31c) verbunden ist,
einen zweiten Strahl (32), der einen zweiten Abschnitt (32a), der mit dem ersten Stützabschnitt (28s) verbunden ist, einen zweiten anderen Abschnitt (32b) und einen zweiten Zwischenabschnitt (32c) zwischen dem zweiten Abschnitt (32a) und dem zweiten anderen Abschnitt (32b) beinhaltet, wobei eine Richtung vom zweiten Abschnitt (32a) zum zweiten anderen Abschnitt (32b) entlang der ersten Richtung verläuft,
eine zweite Strahlelektrode (32E), die mit dem zweiten Zwischenabschnitt (32c) verbunden ist, und
eine zweite Gegenstrahlelektrode (32AE), die mit dem zweiten Zwischenabschnitt (32c) verbunden ist,
eine zweite Richtung vom ersten Zwischenabschnitt (31c) zur ersten Strahlelektrode (31E) die erste Richtung kreuzt,
eine Richtung vom zweiten Zwischenabschnitt (32c) zur zweiten Strahlelektrode (32E) entlang der zweiten Richtung verläuft,
eine Richtung vom zweiten Strahl (32) zum ersten Strahl (31) entlang der zweiten Richtung verläuft,
der erste Strahl (31) zwischen der ersten Gegenstrahlelektrode (31AE) und der ersten Strahlelektrode (31E) in der zweiten Richtung bereitgestellt ist,
der zweite Strahl (32) zwischen der zweiten Gegenstrahlelektrode (32AE) und der zweiten Strahlelektrode (32E) in der zweiten Richtung bereitgestellt ist und
die erste Strahlelektrode (31E) und die zweite Strahlelektrode (32E) mindestens eine von einer ersten Bedingung, einer zweiten Bedingung, einer dritten Bedingung, einer vierten Bedingung, einer fünften Bedingung, einer sechsten Bedingung, einer siebten Bedingung oder einer achten Bedingung erfüllen,
unter der ersten Bedingung sich eine zweite Masse der zweiten Strahlelektrode (32E) von einer ersten Masse der ersten Strahlelektrode (31E) unterscheidet,
unter der zweiten Bedingung sich mindestens ein Teil eines zweiten Materials, das in der zweiten Strahlelektrode (32E) beinhaltet ist, mindestens von einem Teil eines ersten Materials, das in der ersten Strahlelektrode (31E) beinhaltet ist, unterscheidet,
unter der dritten Bedingung sich eine zweite Dicke der zweiten Strahlelektrode (32E) entlang einer dritten Richtung von einer ersten Dicke der ersten Strahlelektrode (31E) entlang der dritten Richtung unterscheidet, wobei die dritte Richtung eine Ebene schneidet, die die erste und die zweite Richtung beinhaltet, und eine Richtung von der Basis (50S) zum ersten festen Abschnitt (10S) entlang der dritten Richtung verläuft,
unter der vierten Bedingung sich eine zweite Größe eines zweiten Lochs (32Eh), die in der zweiten Strahlelektrode (32E) beinhaltet ist, von einer ersten Größe eines ersten Lochs (31Eh), die in der ersten Strahlelektrode (31E) beinhaltet ist, unterscheidet,
unter der fünften Bedingung sich eine zweite Dichte der zweiten Löcher (32Eh) von der ersten Dichte der ersten Löcher (31Eh) unterscheidet,
unter der sechsten Bedingung sich eine zweite Zahl der zweiten Löcher (32Eh) von einer ersten Zahl der ersten Löcher (31Eh) unterscheidet oder die zweite Strahlelektrode (32E) die zweiten Löcher (32Eh) beinhaltet und die erste Strahlelektrode (31E) das erste Loch (31Eh) nicht beinhaltet,
unter der siebten Bedingung sich eine zweite Schichtstruktur der zweiten Strahlelektrode (32E) von einer ersten Schichtstruktur der ersten Strahlelektrode (31E) unterscheidet und
unter der achten Bedingung sich eine zweite Form der zweiten Strahlelektrode (32E) von einer ersten Form der ersten Strahlelektrode (31E) unterscheidet und
wobei
das Elementsegment (10E) weiter ein bewegliches Element (20M) beinhaltet, das von dem ersten festen Abschnitt (10S) gestützt wird,
das bewegliche Element (20M) einen ersten beweglichen Abschnitt (21a) beinhaltet, und
der erste andere Abschnitt (31b) und der zweite andere Abschnitt (32b) mit dem ersten beweglichen Abschnitt (21a) verbunden sind,
wobei der Sensor (110-110g, 111-117, 120-123a) weiter umfasst
eine erste feste Elektrode (51E) und eine zweite feste Elektrode (52E), die an der Basis befestigt sind,
die erste feste Elektrode (51E) der ersten Strahlelektrode (31E) zugewandt ist,
die zweite feste Elektrode (52E) der zweiten Strahlelektrode (32E) zugewandt ist.

2. Sensor (110-110g, 111-117, 120-123a) nach Anspruch 1, wobei
das bewegliche Element (20M) weiter beinhaltet
einen ersten beweglichen Basisabschnitt (21B), der von dem ersten festen Abschnitt (10S) gestützt wird,
einen ersten beweglichen Zwischenabschnitt (21M), der zwischen dem ersten beweglichen Basisabschnitt (21B) und dem ersten beweglichen Abschnitt (21a) bereitgestellt ist, und
einen ersten beweglichen Verbindungsabschnitt (21C), der zwischen dem ersten beweglichen Basisabschnitt (21B) und dem ersten beweglichen Zwischenabschnitt (21M) bereitgestellt ist,
wobei eine Breite des ersten beweglichen Verbindungsabschnitts (21C) in der zweiten Richtung schmaler ist als eine Breite des ersten beweglichen Basisabschnitts (21B) in der zweiten Richtung, und
die Breite des ersten beweglichen Verbindungsabschnitts schmaler ist als eine Breite des ersten beweglichen Zwischenabschnitts (21M) in der zweiten Richtung.

3. Sensor (110-110g, 111-117, 120-123a) nach einem der Ansprüche 1-2, wobei
die erste Strahlelektrode (31E) beinhaltet
einen ersten, sich in der ersten Richtung erstreckenden Erstreckungsabschnitt (31Ex) und
einen ersten, sich erstreckenden Verbindungsabschnitt (31Ec), der den ersten Erstreckungsabschnitt (31Ex) mit dem ersten Zwischenabschnitt (31c) verbindet, und
die zweite Strahlelektrode (32E) beinhaltet
einen zweiten Erstreckungsabschnitt (32Ex) entlang der ersten Richtung und
einen zweiten, sich erstreckenden Verbindungsabschnitt (32Ec), der den zweiten Erstreckungsabschnitt (32Ex) mit dem zweiten Zwischenabschnitt (32c) verbindet.

4. Sensor (110-110g, 111-117, 120-123a) nach Anspruch 1, wobei
die erste Gegenstrahlelektrode (31AE) und die zweite Gegenstrahlelektrode (32AE) mindestens eine von einer neunten Bedingung, einer zehnten Bedingung, einer elften Bedingung, einer zwölften Bedingung, einer dreizehnten Bedingung, einer vierzehnten Bedingung, einer fünfzehnten Bedingung oder einer sechzehnten Bedingung erfüllen,
unter der neunten Bedingung sich eine zweite Gegenmasse der zweiten Gegenstrahlelektrode (32AE) von der ersten Gegenmasse der ersten Gegenstrahlelektrode (31AE) unterscheidet,
unter der zehnten Bedingung sich mindestens ein Teil eines zweiten Gegenmaterials, das in der zweiten Gegenstrahlelektrode (32AE) beinhaltet ist, von mindestens einem Teil eines ersten Gegenmaterials, das in der ersten Gegenstrahlelektrode (31AE) beinhaltet ist, unterscheidet,
unter der elften Bedingung sich eine zweite Gegendicke entlang der dritten Richtung der zweiten Gegenstrahlelektrode (32AE) von einer ersten Gegendicke entlang der dritten Richtung der ersten Gegenstrahlelektrode (31AE) unterscheidet,
unter der zwölften Bedingung sich eine zweite Gegengröße eines zweiten Gegenlochs (32AEh), das in der zweiten Gegenstrahlelektrode (32AE) beinhaltet ist, von einer ersten Gegengröße eines ersten Gegenlochs (31AEh), das in der ersten Gegenstrahlelektrode (31AE) beinhaltet ist, unterscheidet,
unter der dreizehnten Bedingung sich eine zweite Gegendichte der zweiten Gegenlöcher (32AEh) von einer ersten Gegendichte der ersten Gegenlöcher (31AEh) unterscheidet,
unter der vierzehnten Bedingung sich eine zweite Gegenzahl der zweiten Gegenlöcher (32AEh) von einer ersten Gegenzahl der ersten Gegenlöcher (31AEh) unterscheidet oder die zweite Gegenstrahlelektrode (32AE) beinhaltet das zweite Gegenloch (32AEh) und die erste Gegenstrahlelektrode (31AE) beinhaltet das erste Gegenloch (31AEh) nicht,
unter der fünfzehnten Bedingung sich eine zweite Gegenschichtstruktur der zweiten Gegenstrahlelektrode (32AE) von einer ersten Gegenschichtstruktur der ersten Gegenstrahlelektrode (31AE) unterscheidet und
unter der sechzehnten Bedingung sich eine zweite Gegenform der zweiten Gegenstrahlelektrode (32AE) von einer ersten Gegenform der ersten Gegenstrahlelektrode (31AE) unterscheidet.

5. Sensor (120-123a) nach Anspruch 1, wobei
eine Position des ersten anderen Abschnitts (31b) in der ersten Richtung zwischen einer Position des ersten Abschnitts (31a) in der ersten Richtung und einer Position des zweiten Abschnitts (32a) in der ersten Richtung bereitgestellt ist und
eine Position des zweiten anderen Abschnitts (32b) in der ersten Richtung zwischen der Position des ersten anderen Abschnitts (31b) in der ersten Richtung und der Position des zweiten Abschnitts (32a) in der zweiten Richtung bereitgestellt ist.

6. Sensor (120-123a) nach Anspruch 5, wobei
das Elementsegment (10E) weiter ein bewegliches Element (20M) beinhaltet, das von dem ersten festen Abschnitt (10S) gestützt wird,
das bewegliche Element (20M) einen ersten beweglichen Abschnitt (21a) beinhaltet,
der erste andere Abschnitt (31b) und der zweite andere Abschnitt (32b) mit dem ersten beweglichen Abschnitt (21a) verbunden sind,
der erste Stützabschnitt (28s) einen ersten Stützbereich (28a), einen zweiten Stützbereich (28b) und einen dritten Stützbereich (28c) beinhaltet,
der erste Abschnitt (31a) vom ersten Stützbereich (28a) gestützt wird,
der zweite Abschnitt (32a) vom zweiten Stützbereich (28b) gestützt wird und
der erste bewegliche Abschnitt (21a) vom dritten Stützbereich (28c) gestützt wird.

7. Sensor (120-123a) nach Anspruch 6, wobei
das bewegliche Element (20M) weiter beinhaltet
einen ersten beweglichen Basisabschnitt (21B), der von dem dritten Stützbereich (28c) gestützt wird, und
einen ersten beweglichen Verbindungsabschnitt (21C), der zwischen dem ersten beweglichen Basisabschnitt (21B) und dem ersten beweglichen Abschnitt (21a) bereitgestellt ist,
wobei eine Breite des ersten beweglichen Verbindungsabschnitts (21C) in der ersten Richtung schmaler ist als eine Breite des ersten beweglichen Basisabschnitts (21B) in der ersten Richtung, und
eine Breite des ersten beweglichen Verbindungsabschnitts in der ersten Richtung schmaler ist als eine Breite des ersten beweglichen Abschnitts (21a).

8. Sensor (120-123a) nach Anspruch 7, wobei
das bewegliche Element (20M) weiter einen ersten beweglichen Gewichtsabschnitt (21W) beinhaltet, der mit dem ersten beweglichen Abschnitt (21a) verbunden ist,
der erste bewegliche Abschnitt (21a) zwischen dem ersten beweglichen Verbindungsabschnitt (21C) und dem ersten beweglichen Gewichtsabschnitt (21W) in der zweiten Richtung bereitgestellt ist und
eine Breite des ersten beweglichen Gewichtsabschnitts in der ersten Richtung des ersten beweglichen Gewichtsabschnitts (21W) größer ist als die Breite des ersten beweglichen Abschnitts.

9. Sensor (120-123a) nach einem der Ansprüche 5-8, wobei
die erste Strahlelektrode (31E) beinhaltet
einen ersten, sich in der ersten Richtung erstreckenden Erstreckungsabschnitt (31Ex) und
einen ersten, sich erstreckenden Verbindungsabschnitt (31Ec), der den ersten Erstreckungsabschnitt (31Ex) mit dem ersten Zwischenabschnitt (31c) verbindet,
die zweite Strahlelektrode (32E) beinhaltet
einen zweiten, sich in der zweiten Richtung erstreckenden Erstreckungsabschnitt (32Ex) und
einen zweiten, sich erstreckenden Verbindungsabschnitt (32Ec), der den zweiten Erstreckungsabschnitt (32Ex) mit dem zweiten Zwischenabschnitt (32c) verbindet.

10. Sensor (110-110g, 111-117, 120-123a) nach einem der Ansprüche 1-9, weiter umfassend:
eine Steuereinheit (70);
wobei die Steuereinheit (70) so konfiguriert ist, dass sie ein erstes Wechselstromsignal zwischen der ersten festen Elektrode (51E) und der ersten Strahlelektrode (31E) anlegt, und
die Steuereinheit (70) so konfiguriert ist, dass sie das erste Wechselstromsignal zwischen der zweiten festen Elektrode (52E) und der zweiten Strahlelektrode (32E) anlegt.

11. Elektronische Vorrichtung (310), umfassend:
den Sensor (110-110g, 111-117, 120-123a) nach einem der Ansprüche 1-10; und
eine Schaltungssteuereinheit (170), die so konfiguriert ist, dass sie eine Schaltung (180) auf Basis eines vom Sensor (110-110g, 111-117, 120-123a) erhaltenen Signals steuert.

## Revendications

1. Capteur (110-110g, 111-117, 120-123a), comprenant :
une base (50S) ;
une première portion fixe (105) fixée à la base (50S) ;
une section d'éléments (10E), un premier espace étant prévu entre la base (50S) et la section d'éléments (10E), la section d'éléments (10E) incluant
une première portion de support (28s) supportée par la première portion fixe (105),
une première poutre (31) incluant une première portion (31a) reliée à la première portion de support (28s), une première autre portion (31b) et une première portion intermédiaire (31c) entre la première portion (31a) et la première autre portion (31b), une direction de la première portion (31a) à la première autre portion (31b) étant le long d'une première direction,
une première électrode de poutre (31E) reliée à la première portion intermédiaire (31c),
une première électrode de poutre opposée (31AE) reliée à la première portion intermédiaire (31c),
une seconde poutre (32) incluant une seconde portion (32a) reliée à la première portion de support (28s), une seconde autre portion (32b) et une seconde portion intermédiaire (32c) entre la seconde portion (32a) et la seconde autre portion (32b), une direction de la seconde portion (32a) à la seconde autre portion (32b) étant le long de la première direction,
une seconde électrode de poutre (32E) reliée à la seconde portion intermédiaire (32c), et
une seconde électrode de poutre opposée (32AE) reliée à la seconde portion intermédiaire (32c),
une deuxième direction de la première portion intermédiaire (31c) à la première électrode de poutre (31E) croisant la première direction,
une direction de la seconde portion intermédiaire (32c) à la seconde électrode de poutre (32E) étant le long de la deuxième direction,
une direction de la seconde poutre (32) à la première poutre (31) étant le long de la deuxième direction,
la première poutre (31) étant prévue entre la première électrode de poutre opposée (31AE) et la première électrode de poutre (31E) dans la deuxième direction,
la seconde poutre (32) étant prévue entre la seconde électrode de poutre opposée (32AE) et la seconde électrode de poutre (32E) dans la deuxième direction, et
la première électrode de poutre (31E) et la seconde électrode de poutre (32E) satisfaisant à au moins une d'une première condition, une deuxième condition, une troisième condition, une quatrième condition, une cinquième condition, une sixième condition, une septième condition ou une huitième condition,
dans la première condition, une seconde masse de la seconde électrode de poutre (32E) étant différente d'une première masse de la première électrode de poutre (31E),
dans la deuxième condition, au moins une partie d'un second matériau inclus dans la seconde électrode de poutre (32E) étant différente d'au moins une partie d'un premier matériau inclus dans la première électrode de poutre (31E),
dans la troisième condition, une seconde épaisseur de la seconde électrode de poutre (32E) le long d'une troisième direction étant différente d'une première épaisseur de la première électrode de poutre (31E) le long de la troisième direction, la troisième direction croisant un plan incluant la première direction et la deuxième direction, une direction de la base (50S) à la première portion fixe (105) étant le long de la troisième direction,
dans la quatrième condition, une seconde taille d'un second trou (32Eh) inclus dans la seconde électrode de poutre (32E) étant différente d'une première taille d'un premier trou (31Eh) inclus dans la première électrode de poutre (31E),
dans la cinquième condition, une seconde densité des seconds trous (32Eh) étant différente de la première densité des premiers trous (31Eh),
dans la sixième condition, un second nombre des seconds trous (32Eh) étant différent d'un premier nombre des premiers trous (31Eh), ou la seconde électrode de poutre (32E) incluant les second trous (32Eh) et la première électrode de poutre (31E) n'incluant pas le premier trou (31Eh),
dans la septième condition, une seconde structure de couche de la seconde électrode de poutre (32E) étant différente d'une première structure de couche de la première électrode de poutre (31E), et
dans la huitième condition, une seconde forme de la seconde électrode de poutre (32E) étant différente d'une première forme de la première électrode de poutre (31E), et
dans lequel
la section d'éléments (10E) inclut en outre un organe mobile (20M) supporté par la première portion fixe (105),
l'organe mobile (20M) inclut une première portion mobile (21a), et
la première autre portion (31b) et la seconde autre portion (32b) sont reliées à la première portion mobile (21a),
le capteur (110-110g, 111-117, 120-123a) comprenant en outre
une première électrode fixe (51E) et une seconde électrode fixe (52E) fixées à la base,
la première électrode fixe (51E) faisant face à la première électrode de poutre (31E),
la seconde électrode fixe (52E) faisant face à la seconde électrode de poutre (32E).

2. Capteur (110-110g, 111-117, 120-123a) selon la revendication 1, dans lequel
l'organe mobile (20M) inclut en outre
une première portion de base mobile (21B) supportée par la première portion fixe (105),
une première portion intermédiaire mobile (21M) prévue entre la première portion de base mobile (21B) et la première portion mobile (21a), et
une première portion de liaison mobile (21C) prévue entre la première portion de base mobile (21B) et la première portion intermédiaire mobile (21M),
une première largeur de portion de liaison mobile de la première portion de liaison mobile (21C) dans la deuxième direction est plus étroite qu'une première largeur de portion de base mobile de la première portion de base mobile (21B) dans la deuxième direction, et
la première largeur de portion de liaison mobile est plus étroite qu'une première largeur de portion intermédiaire mobile de la première portion intermédiaire mobile (21M) dans la deuxième direction.

3. Capteur (110-110g, 111-117, 120-123a) selon l'une quelconque des revendications 1-2, dans lequel
la première électrode de poutre (31E) inclut
une première portion d'extension (31Ex) s'étendant le long de la première direction, et
une première portion de liaison d'extension (31Ec) reliant la première portion d'extension (31Ex) à la première portion intermédiaire (31c), et
la seconde électrode de poutre (32E) inclut
une seconde portion d'extension (32Ex) le long de la première direction, et
une seconde portion de liaison d'extension (32Ec) reliant la seconde portion d'extension (32Ex) à la seconde portion intermédiaire (32c).

4. Capteur (110-110g, 111-117, 120-123a) selon la revendication 1, dans lequel
la première électrode de poutre opposée (31AE) et la seconde électrode de poutre opposée (32AE) satisfont à au moins une d'une neuvième condition, une dixième condition, une onzième condition, une douzième condition, une treizième condition, une quatorzième condition, une quinzième condition ou une seizième condition,
dans la neuvième condition, une seconde masse opposée de la seconde électrode de poutre opposée (32AE) est différente de la première masse opposée de la première électrode de poutre opposée (31AE),
dans la dixième condition, au moins une partie d'un second matériau opposé inclus dans la seconde électrode de poutre opposée (32AE) est différente d'au moins une partie d'un premier matériau opposé inclus dans la première électrode de poutre opposée (31AE),
dans la onzième condition, une seconde épaisseur opposée le long de la troisième direction de la seconde électrode de poutre opposée (32AE) est différente d'une première épaisseur opposée le long de la troisième direction de la première électrode de poutre opposée (31AE),
dans la douzième condition, une seconde taille opposée d'un second trou opposé (32AEh) inclus dans la seconde électrode de poutre opposée (32AE) est différente d'une première taille opposée d'un premier trou opposé (31AEh) inclus dans la première électrode de poutre opposée (31AE),
dans la treizième condition, une seconde densité opposée des seconds trous opposés (32AEh) est différente d'une première densité opposée des premiers trous opposés (31AEh),
dans la quatorzième condition, un second nombre opposé des seconds trous opposés (32AEh) est différent d'un premier nombre opposé des premiers trous opposés (31AEh), ou la seconde électrode de poutre opposée (32AE) inclut le second trou opposé (32AEh) et la première électrode de poutre opposée (31AE) n'inclut pas le premier trou opposé (31AEh),
dans la quinzième condition, une seconde structure de couche opposée de la seconde électrode de poutre opposée (32AE) est différente d'une première structure de couche opposée de la première électrode de poutre opposée (31AE), et
dans la seizième condition, une seconde forme opposée de la seconde électrode de poutre opposée (32AE) est différente d'une première forme opposée de la première électrode de poutre opposée (31AE).

5. Capteur (120-123a) selon la revendication 1, dans lequel
une position de la première autre portion (31b) dans la première direction est prévue entre une position de la première portion (31a) dans la première direction et une position de la seconde portion (32a) dans la première direction, et
une position de la seconde autre portion (32b) dans la première direction est prévue entre la position de la première autre portion (31b) dans la première direction et la position de la seconde portion (32a) dans la deuxième direction.

6. Capteur (120-123a) selon la revendication 5, dans lequel
la section d'éléments (10E) inclut en outre un organe mobile (20M) supporté par la première portion fixe (10S),
l'organe mobile (20M) inclut une première portion mobile (21a),
la première autre portion (31b) et la seconde autre portion (32b) sont reliées à la première portion mobile (21a),
la première portion de support (28s) inclut une première région de support (28a), une deuxième région de support (28b) et une troisième région de support (28c),
la première portion (31a) est supportée par la première région de support (28a),
la seconde portion (32a) est supportée par la deuxième région de support (28b), et
la première portion mobile (21a) est supportée par la troisième région de support (28c).

7. Capteur (120-123a) selon la revendication 6, dans lequel
l'organe mobile (20M) inclut en outre
une première portion de base mobile (21B) supportée par la troisième région de support (28c), et
une première portion de liaison mobile (21C) prévue entre la première portion de base mobile (21B) et la première portion mobile (21a),
une première largeur de portion de liaison mobile de la première portion de liaison mobile (21C) dans la première direction est plus étroite qu'une première largeur de base mobile de la première portion de base mobile (21B) dans la première direction, et
une première largeur de portion de liaison mobile est plus étroite qu'une première largeur de portion mobile de la première portion mobile (21a) dans la première direction.

8. Capteur (120-123a) selon la revendication 7, dans lequel
l'organe mobile (20M) inclut en outre une première portion de poids mobile (21W) reliée à la première portion mobile (21a),
la première portion mobile (21a) est prévue entre la première portion de liaison mobile (21C) et la première portion de poids mobile (21W) dans la deuxième direction, et
une première largeur de portion de poids mobile dans la première direction de la première portion de poids mobile (21W) est plus large que la première largeur de portion mobile.

9. Capteur (120-123a) selon l'une quelconque des revendications 5-8, dans lequel
la première électrode de poutre (31E) inclut
une première portion d'extension (31Ex) s'étendant le long de la première direction, et
une première portion de liaison d'extension (31Ec) reliant la première portion d'extension (31Ex) à la première portion intermédiaire (31c),
la seconde électrode de poutre (32E) inclut
une seconde portion d'extension (32Ex) s'étendant le long de la deuxième direction, et
une seconde portion de liaison d'extension (32Ec) reliant la seconde portion d'extension (32Ex) à la seconde portion intermédiaire (32c).

10. Capteur (110-110g, 111-117, 120-123a) selon l'une quelconque des revendications 1-9, comprenant en outre :
un dispositif de commande (70) ;
le dispositif de commande (70) étant configuré pour appliquer un premier signal CA entre la première électrode fixe (51E) et la première électrode de poutre (31E), et
le dispositif de commande (70) étant configuré pour appliquer le premier signal CA entre la seconde électrode fixe (52E) et la seconde électrode de poutre (32E).

11. Dispositif électronique (310), comprenant :
le capteur (110-110g, 111-117, 120-123a) selon l'une quelconque des revendications 1-10 ; et
un dispositif de commande de circuit (170) configuré pour commander un circuit (180) sur la base d'un signal obtenu à partir du capteur (110-110g, 111-117, 120-123a).
